# EUROPEAN PATENT APPLICATION

(11) **EP 4 790 744 A1**
(43) Date of publication of application: **12.08.2026**
(21) Application number: 25156829.1
(22) Date of filing: 10.02.2025
(51) Int. Cl.: H01L 21/67, B25J 15/00, B25J 15/06, H02K 7/09, H02K 21/12, H02K 37/00, H02P 6/28, H02K 29/00

(54) **STAGE FOR DIE PLACEMENT**

(71) Applicant: ASML Netherlands B.V., 5500 AH Veldhoven (NL)
(72) Inventor: SEIJGER, Olav, Johannes, 5500 AH Veldhoven (NL); RENKENS, Michael, Jozefa, Mathijs, 5500 AH Veldhoven (NL); RIJS, Robertus, Mathijs, Gerardus, 5500 AH Veldhoven (NL); BEUKMAN, Arjan, Johannes, Anton, 5500 AH Veldhoven (NL); GOUTEUX, Louise, Karina, Laurie, 5500 AH Veldhoven (NL); ENDENDIJK, Wilfred, Edward, 5500 AH Veldhoven (NL)
(74) Representative: ASML Netherlands B.V.

(57) **Abstract**

A stage for die placement comprises a support member; a movable member that is movable relative to the support member, wherein the movable member is configured to hold at least one die; and an actuator configured, on actuation, to move the movable member relative to the support member in six degrees of freedom.

## Description

### TECHNICAL FIELD

The present disclosure relates generally to a stage for die placement, a bonding tool, a method of placing a die and an actuator for driving rotating movement.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in die placement and alignment (e.g., improvements in heterogeneous integration) lead to improvements in IC manufacturing and integration abilities.

### SUMMARY

According to an embodiment, there is provided a stage for die placement comprising: a support member; and a movable member that is movable relative to the support member, wherein the movable member is configured to hold at least one die; and an actuator configured, on actuation, to move the movable member relative to the support member in six degrees of freedom.

According to an embodiment, there is provided a method of placing a die, the method comprising: actuating an actuator to move a movable member relative to a support member in six degrees of freedom, wherein the movable member holds a die.

According to an embodiment, there is provided an actuator configured to drive a rotating movement comprising: a first member comprising a circularly arranged plurality of coils; and a second member that is rotatable relative to the first member and comprising a plurality of magnetic field generating elements arranged substantially concentric with the plurality of coils, characterized in that at least one magnetic field generating element and coil are relatively positioned such to enable force generation in a direction perpendicular to the rotating movement.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 is. a schematic diagram of a Lorentz force actuator of a stage for die placement.
Figure 4 is a schematic view of a group of coils of the Lorentz force actuator of Figure 3.
Figure 5 is a side view of the Lorentz force actuator of Figure 3.
Figure 6 is a perspective view of the magnet track of the Lorentz force actuator of Figure 3.
Figure 7 is a perspective view of a stage for die placement.
Figure 8 is a perspective view of an alternative stage for die placement.
Figure 9 is a schematic end view of a Lorentz force actuator.
Figure 10 is a schematic side view of a Lorentz force actuator and a long stroke actuator.
Figure 11 is a schematic view of an alternative implementation of a Lorentz force actuator and a long stroke actuator.
Figure 12, Figure 13, Figure 14, Figure 15 and Figure 16 are schematic views of a secondary member of a stage for die placement at different times of use.
Figure 17 and Figure 18 are schematic views of an alternative secondary member at different times of use.
Figure 19 is a schematic view of an alternative secondary member.
Figure 20 and Figure 21 are schematic views of an alternative secondary member at different times of use.
Figure 22 is an end view of an alternative secondary member.
Figure 23 is a side view of the secondary member of Figure 22.
Figure 24 is a perspective view of the secondary member of Figure 22.
Figure 25 and Figure 26 are schematic views of an alternative secondary member at different times of use.
Figure 27, Figure 28 and Figure 29 are schematic views of measurement systems for the stage for die placement.
Figure 30 schematically depicts an angle measurement surface of the stage for die placement.
Figure 31 and Figure 32 schematically depict a measurement system for the stage for die placement.
Figure 33 schematically depicts an alternative measurement system for the stage for die placement.
Figure 34 is an enlarged view of part of the stage shown in Figure 33.
Figure 35 schematically shows an enlarged view of part of an alternative stage for die placement.
Figure 36, Figure 37 and Figure 38 are schematic views of alternative measurement systems for the stage for die placement.
Figure 39 is an enlarged view of a grating of the stage for die placement.
Figure 40 is a schematic view of an alternative measurement system for the stage for die placement.
Figure 41 is a schematic view of alternative gratings on the stage for die placement.
Figure 42 is a schematic view of a measurement system for the stage shown in Figure 41.
Figure 43 is a schematic view of a measurement system for a stage for die placement.
Figure 44 is a perspective view of the measurement system shown in Figure 43.
Figure 45 is a schematic view of part of the measurement system shown in Figure 43 and Figure 44.
Figure 46 is a schematic view of an alternative measurement system for the stage for die placement.
Figure 47 is a schematic view of an alternative measurement system for the stage for die placement.
Figure 48 is an alternative view of the measurement system shown in Figure 47.
Figure 49 is a diagram of part of the measurement system shown in Figure 47 and Figure 48.
Figure 50, Figure 51 and Figure 52 relate to different steps of a process of measuring the position of the stage for die placement.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

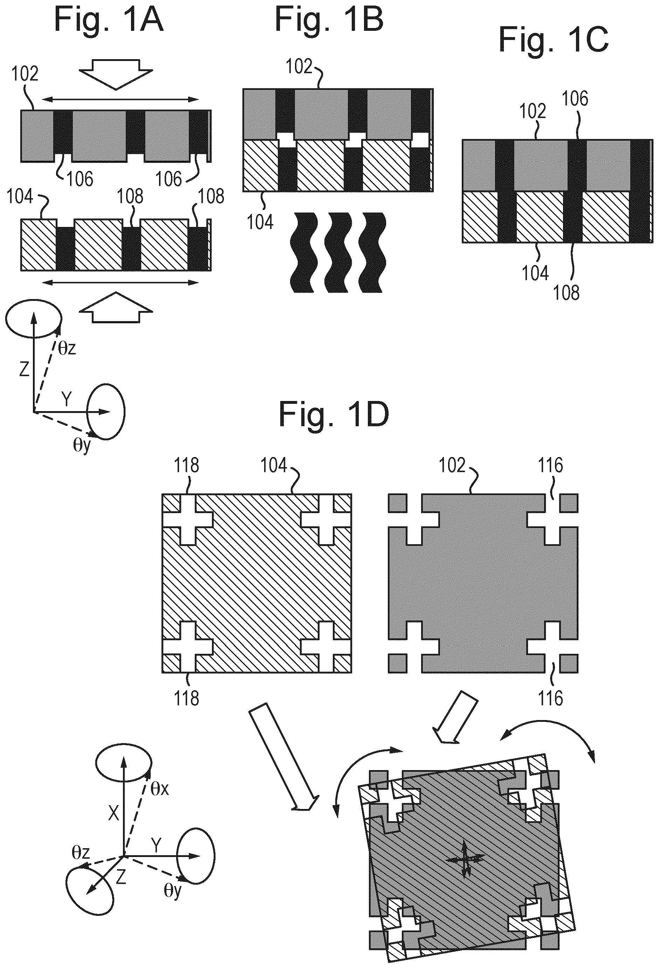

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1 A, the donor die 102 and the target die 104 may be brought together along the z-axis, while the position of the donor die 102 or the target die 104 may be adjusted in the x-y plane (e.g., perpendicular to the z-axis of approach). As shown in Figure IB, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure ID depicts a plan view of an example die bonding method according to this disclosure. As shown in Figure ID, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure ID) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

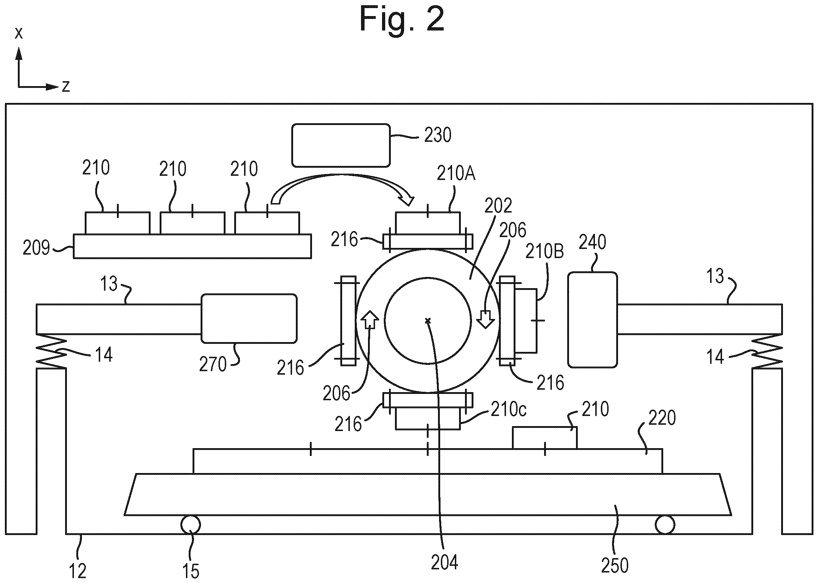

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 210A-210D using support stage 202. The support stage 202 is substantially circular in the x-z plane, with a longitudinal axis 204 along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has die acceptors 216. The placement of the die acceptors 216 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces. The die acceptors 216 are capable of accepting donor dies, such as the donor dies 210A- 210D.

The support stage 202 may be controllably moved in a direction 206 about the longitudinal axis 204. The direction 206 is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis 204. The support stage 202 may move continuously or intermittently. For example, the support stage 202 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

A first position, such as corresponding to the position depicted for the donor die 210A, may correspond to placement of die in die acceptors 216 of the support stage 202. The donor die 210A may be placed on the die acceptor 216 by a pick and place element 230. The pick and place element 230 may place the donor die 210A on the support stage 202 on the die acceptor 216 based on alignment information, based on positional information of the support stage 202, etc. The pick and place element 230 may place the donor die 210A on the support structure at a given position relative to the die acceptor 216. For example, the pick and place element 230 may center the donor die 210A relative to the die acceptor 216. The pick and place element 230 may have intrinsic error or inaccuracy.

The second position, such as corresponding to the position depicted for the donor die 210B, may correspond to measurement of the position of the die in recesses (e.g., of the donor die 210B relative to the die acceptor 216) of the support stage 202. The position (e.g., location) of the donor die 210B may be measured by a location measurement element 240. The location measurement element 240 may measure an actual position of the donor die 210B, in relative (such as relative to the die acceptor 216) or absolute terms (such as in distances from an origin point on the support stage 202, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an inplane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202.

Once the position of the donor die 210B is measured, the support stage 202 may move (e.g., in the direction 206), so that the donor die 210B occupies the position of the donor die 210C which may be a third position of the support stage 202. The third position of the support structure will now be described with reference to the donor die 210C.

The third position, such as corresponding to the position depicted for the donor die 210C, may correspond to placement of the die on a corresponding target, for example, an acceptor substrate 220. The acceptor substrate 220 may comprise one or more target dies which may be sequentially contacted by a donor die during various movements of the support stage 202.

The acceptor substrate 220 is supported by the support structure 250. The donor die 210C may be placed on the acceptor substrate 220 by motion of the support stage 202 towards the acceptor substrate 220. Alternatively or additionally, the support structure 250 may also be a moveable structure operable to bring the donor die 210C and the acceptor substrate 220 into contact.

Once the donor die 210C is placed on the acceptor substrate 220, the support stage 202 and the support structure 250 may operate (individually or in concert) to place additional donor dies on the acceptor substrate 220. For example, the support structure 250 may move in the negative z-direction so that another part of the acceptor substrate 220 is proximate to the support stage 202 and a donor die (for example, the donor die 210B after rotation of the support stage 202) may be placed on the acceptor substrate 220. The relative motion of the support stage 202 and the support structure 250 may occur in any appropriate direction. A direction of gravity is not depicted, but the placement of the donor die 210C on the acceptor substrate 220 may experience gravitation effects. For example, the placement of the donor die 210C on the acceptor substrate 220 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 202 shown in Figure 2 is for die placement. The stage 202 is for placing dies 210, for example onto an acceptor substrate 220. The stage 202 comprises an actuator. The actuator is configured to cause the stage 202 to accept the dies 210 from pick & place element 230 and subsequently transport the dies 210 to alignment sensor 240 and finally place the dies 210 on the acceptor substrate 220.

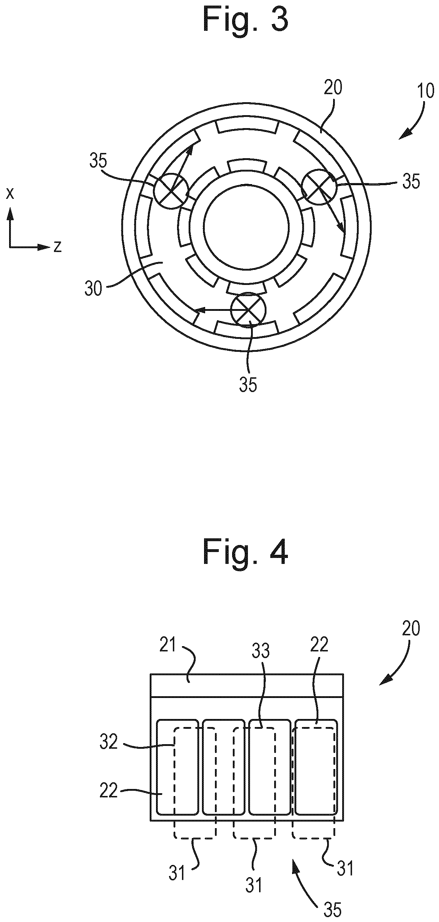

Figure 3 is a schematic view of an actuator for the stage 202. The actuator may be a Lorentz force actuator 10 or any other actuator suitable to provide actuation in six degrees of freedom. In case of using a Lorentz force actuator 10 the actuator is configured to apply Lorentz forces to cause the stage 202 to move at least one die 210, for example for placement of the die 210.

In an embodiment the stage 202 comprises a support member 30 and a movable member 20. The movable member 20 is movable relative to the support member 30. The movable member 20 is configured to hold at least one die 210. For example, as shown in Figure 2 in an embodiment the movable member 20 is configured to hold four dies 210. The movable member 20 may comprise at least one die acceptor 216. As shown in Figure 2, in an embodiment the movable member 20 comprises a plurality of die acceptors 216, for example at least four die acceptors 216. Each die acceptor 216 may be configured to hold a die 210. The die acceptors 216 may be provided at an outward facing surface of the movable member 20.

In an embodiment, the actuator 10 is configured, on actuation, to move the movable member 20 relative to the support member 30. In an embodiment the actuator 10 is configured, on actuation, to move the movable member 20 relative to the support member 30 in six degrees of freedom. The six degrees of freedom may be movement in the X direction (i.e. the vertical direction shown in Figure 2), movement in the Z direction (i.e. the horizontal direction shown in Figure 2), movement in the Y direction (i.e. into and out of the plane of Figure 2), rotation about the Y axis, tilt about the X axis and tilt about the Z axis. The actuator 10 may be a Lorentz force actuator 10.

The (Lorentz force) actuator 10 is configured to move the movable member 20 relative to the support member 30 at high accuracy. High accuracy is required for placing the dies 210 onto the acceptor substrate 220.

As shown in Figure 2, in an embodiment the acceptor substrate 220 is supported by a support structure 250. In an embodiment the support structure 250 is configured to move the acceptor substrate 220 at high accuracy. In an embodiment, a controller is configured to control the stage 202 and the support structure 250 so as to accurately place the die 210 from the donor substrate 209 to the acceptor substrate 220.

The Lorentz force actuator 10 is configured, on actuation, to move the movable member 20 relative to the support member 30 with substantially zero friction. An embodiment of the invention is expected to achieve high accuracy of die placement.

Figure 2 schematically depicts a bonding tool for bonding a die 210 to an acceptor substrate 220. The bonding tool comprises the stage 202 for die placement.

As shown in Figure 2, in an embodiment the bonding tool comprises a base frame 12. As shown in Figure 2, in an embodiment the support structure 250 that supports the acceptor substrate 220 is coupled to the base frame 12 by at least one bearing 15. In an embodiment the support structure 250 comprises a plurality of stages that may be stacked relative to each other via a plurality of bearings. For example, the support structure 250 may comprise a long stroke module for relatively coarse positioning of the acceptor substrate 220 over a longer distance, and a short stroke module for higher accuracy positioning of the acceptor substrate 220 over a shorter stroke. The short stroke module may be stacked on the long stroke module.

As shown in Figure 2, in an embodiment the bonding tool comprises a metrology frame 13. The metrology frame 13 may be referred to as an isolated frame. The metrology frame 13 may be isolated relative to the base frame 12.

For example, as shown in Figure 2, in an embodiment the bonding tool comprises an isolator 14. The isolator 14 is configured to substantially isolate the metrology frame 13 from the base frame 12. By isolating the metrology frame 13 from the base frame 12, vibrations of the base frame 12 may have less effect on the metrology frame 13.

For example, in an embodiment measurements of the location of a die 210 may be made relative to the metrology frame 13. An embodiment of the invention is expected to achieve high accuracy of positioning of a die 210.

In an embodiment the support member 30 of the Lorentz force actuator 10 is secured to the base frame 12. For example, the support member 30 is fixed to the base frame 12. In an embodiment, the position of the movable member 20 is measured and controlled with respect to the metrology frame 13.

An embodiment of the invention is expected to have relatively low sensitivity of the movable member 20 for external vibrations. This can help to achieve high position accuracy of the movable member 20, and therefore the at least one die 210 to be placed.

An embodiment of the invention is expected to achieve high internal eigenfrequencies of the movable member 20. Such high internal eigenfrequencies are expected to allow a high control bandwidth to be realised. This is expected to result in high position accuracy of the movable member 20.

The Lorentz force actuator 10 is configured to move the movable member 20 relative to the support member 30 in six degrees of freedom. An embodiment of the invention is expected to achieve accurate positioning of the movable member 20 in six degrees of freedom. For example, referring to the coordinate system shown in Figure 2, rotation about the Y axis can be achieved, translation in the X direction can be achieved for placing the die 210 onto the acceptor substrate 220, and movement in the other four degrees of freedom can be performed to achieve accurate placing of the die 210 on the acceptor substrate 220.

As shown in Figure 2 and Figure 3, in an embodiment the movable member 20 comprises a rotatable wheel. The movable member 20 may be referred to as a turret. However, it is not essential for the movable member 20 to be formed as a wheel or a turret. It is not essential for the stage 202 to perform die placement by rotation (and flipping) of the dies 210.

In an alternative embodiment, the stage 202 comprises a Lorentz force actuator 10 configured to move the movable member relative to the support member for die placement without rotating the die 210. For example, the donor substrate 209 may be positioned generally to the side of the acceptor substrate 220. The stage 202 may be configured to move the die 210 from the donor substrate 209 to the acceptor substrate 220 by lifting the die 210 from the donor substrate 209, translating the die 210 in a generally horizontal direction over the acceptor substrate 220 and placing the die 210 down onto the acceptor substrate 220. The stage 202 comprises the Lorentz force actuator 10 for moving the movable member relative to the support member in six degrees of freedom. The Lorentz force actuator 10 allows the stage 202 to perform high accuracy placement of the dies 210.

Embodiments of the invention are primarily described with reference to embodiments in which the movable member 20 is generally wheel shaped. Unless specific reference is made to the geometry of the stage 202, it is to be understood that such a wheel shape is not required.

As shown in Figure 2, in an embodiment the bonding tool comprises at least one location measurement element 240, which may be referred to as an alignment sensor. As shown in Figure 2, the location measurement element 240 may be secured to the metrology frame 13. As shown in Figure 2, in an embodiment the bonding tool comprises an acceptor exchange element 270. The acceptor exchange element 270 may be secured to the metrology frame 13. The acceptor exchange element 270 is configured to exchange a die acceptor 216 of the stage 202 for a replacement die acceptor. Alternatively, the nozzle exchange element 270 may be omitted.

As shown in Figure 2, in an embodiment the bonding tool comprises the pick and place element 230. The pick and place element 230 may be referred to as a pick and place robot.

Figure 3 and Figure 4 schematically show features of the Lorentz force actuator 10 of the stage 202. In an embodiment the Lorentz force actuator 10 comprises a plurality of coils. Each coil 31 comprises a coil 31 of wire for carrying an electric current. As shown in Figure 3, in an embodiment the Lorentz force actuator 10 comprises at least three groups 35 of coils. Each group 35 comprises at least three coils 31. The coils 31 are arranged such that Lorentz forces are applicable in two degrees of freedom.

It is not essential for there to be three groups 35 of coils 31. In an alternative arrangement, the coil unit comprises more than three groups 35. For example, the coil unit may comprise four, five or more than five groups 35. It is not essential for each group 35 to comprise three coils 31. In an alternative embodiment, one or more of the groups 35 comprises at least four, at least five, at least six or more than six coils 31.

Figure 3 schematically shows the directions of the two degrees of freedom of the Lorentz forces corresponding to each of the three groups 35 of coils 31. Forces are in two degrees of freedom per group 35 of three coils 31. By providing three groups 35, forces can be applied in six degrees of freedom.

Figure 3 schematically shows that each group 35 can produce a force in the rotation direction (i.e. rotation around the Y axis) and in an axial direction (i.e. parallel to the Y axis). Translation in the X direction can be achieved by actuating the rotation force for one of the upper two groups 35, together with the rotation force of the lower group 35 (so as to compensate for force in the Z direction). Alternatively, translation in the X direction can be achieved by actuating one of the upper two groups 35 with a certain current and the other of the upper two groups 35 with the identical current in the opposite direction such that both Z components cancel each other out and the resulting force is vertical (in X direction). The lower group 35 may not be needed for a vertical force. Translation in the Y direction may be achieved by actuating the axial force of the three groups 35. Translation in the Z direction can be achieved by actuating the bottom coil 35 and the combination of the two upper coils (such that the forces in the X direction compensate each other). Tilt about the X axis can be achieved by actuating the axial force of one of the upper two groups 35 while actuating the axial force of the lower group 35 (so as to compensate for tilt about the Z axis). Rotation about the Y axis may be achieved by actuating the rotational force of all three groups 35. Tilt about the Z axis may be achieved by actuating the axial force of the lower group 35 or the axial forces of the two upper groups 35 in combination (so that their forces about the X axis compensate for each other).

Figure 4 is a schematic view of a group 35 of coils 31 of the Lorentz force actuator 10. As shown in Figure 4, in an embodiment the Lorentz force actuator comprises a magnet track comprising magnets 22. The magnets 22 may be permanent magnets or electromagnets. Alternatively the magnets 22 may be referred to as magnetic field generating elements 22 (both terms considered to be equivalent in this document). The magnets (magnetic field generating elements) 22 are configured to generate a magnetic field within a channel. The channel is defined by the magnet track. For example, in Figure 3 the magnet track comprises an outer track radially outward of the groups 35 of coils. The magnet track further comprises an inner track that is radially inward of the groups 35 of coils. The magnet track defines a channel in which the groups 35 of coils 31 are provided. In the arrangement shown in Figure 3, the channel is substantially circular between the outer track and the inner track.

In an embodiment, the coils 31 are arranged at least partly within the channel such that relative movement between the coils 31 and the magnet track causes relative movement between the support member 30 and the movable member 20. The magnet track may be comprised in one of the support member 30 and the movable member 20. The coils may be comprised in the other of the movable member 20 and the support member 30. The present invention is described primarily with reference to embodiments in which the magnet track is comprised in the movable member 20 and the coils are comprised in the support member 30. However, in an alternative arrangement, the magnet track is comprised in the support member 30 and the coils are comprised in the movable member 20. Figure 3 shows an arrangement in comprising a single ring of a coil-magnet pair. In an alternative embodiment the stage 202 comprises a plurality of rings of coil-magnet pairs. Each coil-magnet pair may be for a respective degree of freedom. For example, a first ring may be for rotational movement. A second ring may be for translational movement along the X axis, etc. As shown in Figure 3, in an embodiment the groups 35 of coils 31 may be centred in the same X-Z plane. However, this is not essential.

As shown in Figure 4, in an embodiment the coils 31 within a group 35 are arranged so as to be at least partially within the magnetic field generated by the magnets 22. As shown in Figure 4, sides 32 of the coils 31 may be arranged within the magnetic field. In an embodiment, a controller is configured to control current carried by the sides 32 of the coils 31 so as to control the force applied between the group 35 of coils 31 and the magnet track of magnets 22. For example, the controller may control timing of currents applied to the coils 31.

As shown in Figure 4, in an embodiment the coil 31 comprises an end 33 positioned within the magnetic field. The end 33 of the coil 31 overlaps the magnets 22 of the movable member 20. In an embodiment the controller is configured to control timing of current applied to the end 33 of the coil 31 of the group 35. In the orientation shown in Figure 4, the sides 32 of the coils 31 allow a force to be generated in the left-right direction. The ends 33 of the coils 31 allow the generation of force in the up/down direction. The group 35 of coils 31 allows Lorentz forces to be provided in two degrees of freedom.

In an embodiment the stage 202 comprises a commutator. The commutator may be effected by the controller of the stage 202. The commutator is configured to apply commutations to the coils 31 such that the Lorentz forces in the different degrees of freedom are substantially independently controllable. In order to allow each group 35 of coils 31 to apply a Lorentz force in two degrees of freedom, two commutations are provided. Dedicated commutations are provided for the respective degrees of freedom associated with each group 35.

As shown in Figure 3, in an embodiment the magnet track is arranged such that the channel forms a closed loop. By providing that the channel forms a closed loop, the movable member 20 may have a substantially infinite stroke relative to the support member 30. There is substantially no end stop provided by the geometry of the Lorentz force actuator 10 that would limit stroke of the movable member 20 relative to the support member 30 for rotation about the Y axis. As shown in Figure 3, in an embodiment the magnet track is arranged such that the channel is substantially annular. However, it is not essential for the channel to be annular. As mentioned elsewhere, it is not essential for the movable member 20 to be arranged as a rotating wheel or as a turret. The movable member 20 may be provided as a platform that generally faces the same direction, albeit allowing small tilts about each axis so as to allow movement in six degrees of freedom.

In an embodiment the groups 35 of coils 31 have substantially fixed positions relative to each other. This allows the actuation of the different groups 35 to be combined so as to effect movement of the movable member 20 relative to the support member 30 in six degrees of freedom. By providing accurate movement in six degrees of freedom, dies 210 may be positioned accurately on the acceptor substrate 220.

Although the Lorentz actuator 10 according to the embodiments described so far is capable of actuating six degrees of freedom, in principle the concept of the proposed actuator may be used to enable actuation of less than six degrees of freedom. For some use cases less than six, but at least one additional degree of freedom, apart from the circular movement needed to rotate the stage 202, may be sufficient to enable position control of the movable member 20 (and hence stage 202). In example the additional degree of freedom is only a movement in the x-direction allowing use of the stage 202 to place for example donor dies on an acceptor substrate. In general the additional degree of freedom will have at least a component perpendicular to the rotating movement of the movable member 20.

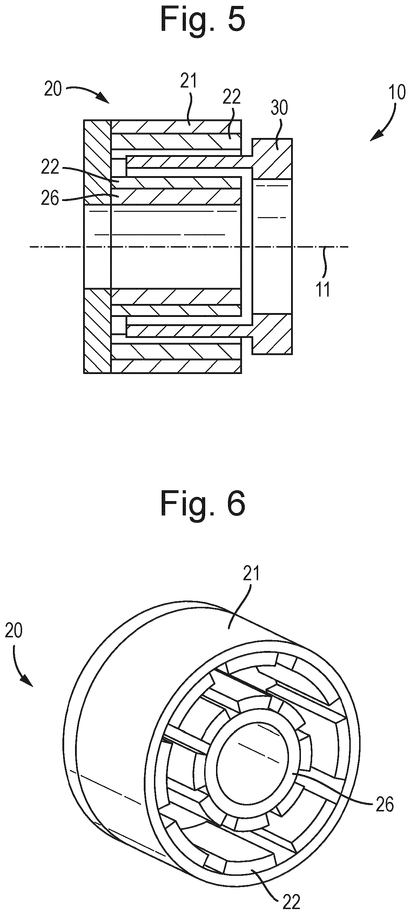

Figure 5 schematically depicts the support member 30 located partially within the channel defined by the magnet track of the movable member 20. The support member 30 may be secured to the base frame 12 (or to the metrology frame 13 alternatively). The movable member 20 can controllably move relative to the support member 30 in six degrees of freedom. As shown in Figure 5, the Lorentz force actuator 10 has a primary axis 11, which may be the Y axis of Figure 2, for example. Figure 5 schematically shows the two series of magnets 22 of the magnet track on opposing sides of the channel. Each series of magnets comprises magnets 22. The magnets 22 may be of alternating polarity. The magnets 22 of alternating polarity may be distanced from each other.

Figure 6 is a schematic perspective view of the movable member 20 shown in Figure 5, for example. The distancing of the magnets 22 from each other is shown in Figure 6. Each series of magnets 22 may comprise an even number of magnets, such that the sequence of magnets 22 is north-south-north-south etc. As shown in Figure 6, in an embodiment gaps are provided between the alternating magnets 22 within each series of the magnet track.

As shown in Figure 3, Figure 4, Figure 5 and Figure 6, for example, in an embodiment the magnet track comprises a first support 21. The first support 21 and the second support 26 may be referred to as magnet supports. The first support 21 and the second support 26 may be configured to mechanically support the respective series of magnets 22.

The first support 21 is configured to support the magnets 22 of one of the series of magnets 22 on one side of the channel. The magnet track may comprise a second support 26. The second support 26 may be configured to support the magnets 22 of the other series of magnets 22 on the opposing side of the channel. The first support 21 and the second support 22 may be configured to mechanically support the magnets 22.

As shown in Figure 6, for example, in an embodiment the first support 21 and the second support 22 are arranged as cylinders (or annuluses). In an alternative arrangement, the first support 21 and the second support 26 may be substantially planar.

In an embodiment, the first support 21 and the second support 26 are substantially rigid. The first support 21 and the second support 26 may be configured to maintain the relative positions of the magnets 22 to each other. For example, the first support 21 and the second support 26 may be configured to maintain the distancing of the magnets 22 from each other. The first support 21 may be configured to maintain the distancing of the magnets 22 at one side of the channel from each other. The second support 26 may maintain the distance between the magnets 22 on the other side of the channel. The circular shape is stiffer than a linear array would be, for a given amount of material. The circular shape is not loaded with any substantial bending force, whereas a linear array would be loaded with a bending force. By arranging the channel as an annulus, the magnetic forces between the two sides of the channel may substantially cancel each other out. Accordingly, it may not be necessary for the first support 21 and the second support 26 to provide a particularly strong yoke for holding the two series of magnets 22 away from each other.

In an embodiment, the first support 21 and/or the second support 26 comprises a magnetic material. For example, the first support 21 and/or the second support 26 may comprise iron, for example a steel. The first support 21 and/or the second support 26 may be configured to strengthen the magnetic field within the channel (compared to if the supports were not made of magnetic material). However, it is not essential for the supports to be magnetic.

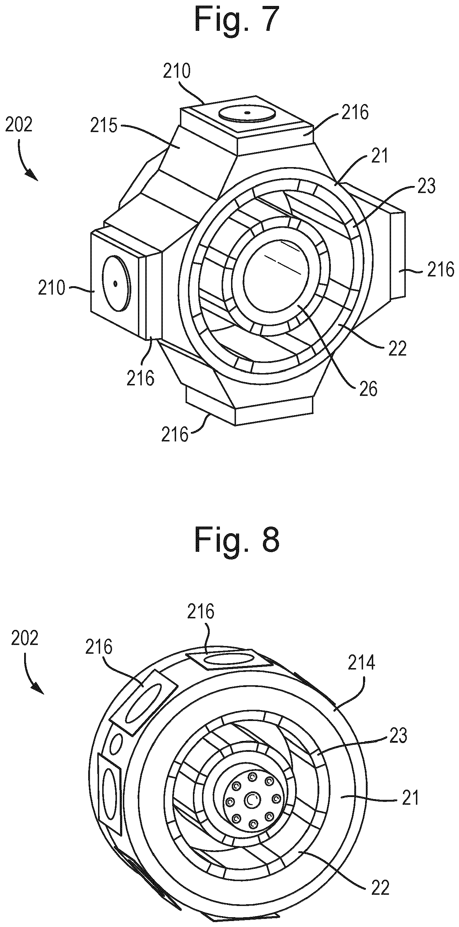

Figure 7 schematically depicts a perspective view of an alternative embodiment of the stage 202. As shown in Figure 7, in an embodiment at least one of the series of magnets 22 comprises at least one Halbach magnet 23. The Halbach magnets 23 connect adjacent magnets 22 of the magnet track. By providing the Halbach magnets 23, the magnet track may comprise a Halbach array. By providing a Halbach array, the magnetic field may be strengthened within the channel. By providing the Halbach magnet, there may be substantially no gaps between the magnets of the magnet track. By providing the Halbach magnets 23, it may not be necessary for the first support 21 or the second support 26 to comprise a magnetic material.

As shown in Figure 7, in an embodiment the movable part 20 comprises at least one acceptor support 215. For example, an acceptor support 215 may be provided for each die acceptor 216. The acceptor support 215 may be configured to connect the die acceptor 216 to the Lorentz force actuator 20, for example to the first support 21 of the magnet track.

As shown in Figure 7, in an embodiment the stage 202 comprises four die acceptors 216. Alternatively, the stage 202 may comprise one, two, three, five, six, seven, eight, or more than eight die acceptors 216. By providing a smaller number of die acceptors 216, the size of the stage 202 may be reduced. By increasing the number of die acceptors 216 of the stage 202, a smaller rotational stroke of the stage 202 may be required in order to place successive dies 210. This may help to increase throughput.

Figure 8 schematically depicts a perspective view of an alternative stage 202 for die placement. The stage 202 shown in Figure 8 comprises eight die acceptors 216. As shown in Figure 8, in an embodiment the stage 202 comprises an acceptor support 214 that is common to a plurality of the die acceptors 216. The acceptor support 214 may be configured to connect the die acceptors 216 to the Lorentz force actuator 10, for example to the first support 21 of the magnet track. The plurality of die acceptors 216 may be located on the same acceptor support 214.

In an embodiment, the die acceptor 216 is configured to hold the die 210 by vacuum pressure. For example, the die acceptor 216 may comprise a nozzle configured to apply an under pressure for holding the die 210 on the die acceptor 216. In an alternative embodiment, the die acceptor 216 is configured to hold the die 210 by an electrostatic force. For example, the die acceptor 216 may comprise an electrostatic clamp. For example, the die acceptor 216 may comprise one or more electrodes to which an electric potential is applied such that the die 210 is electrostatically attracted to the die acceptor 216.

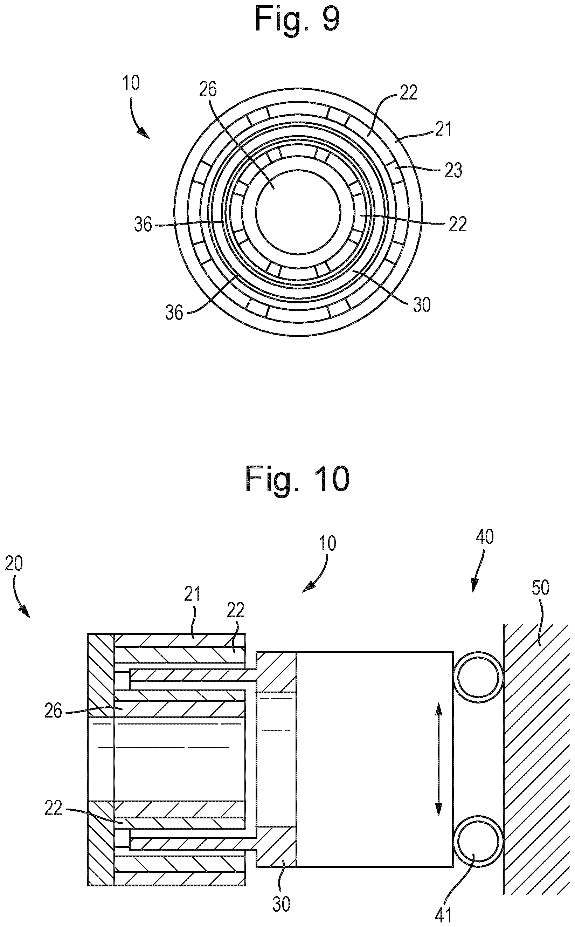

Figure 9 schematically depicts an end view (along the Y axis) of an alternative Lorentz force actuator 10. As shown in Figure 9, in an embodiment the Lorentz force actuator 10 comprises a thermal conditioner 36. The thermal conditioner 36 is configured to thermally condition the coils 31. For example, in the embodiment shown in Figure 9, the thermal conditioner 36 is provided to the support member 30. The support member 30 comprises groups 35 of coils 31. During use of the Lorentz force actuator 10, the currents applied to the coils may cause the coils 31 to heat up, for example by resistive heating. In an embodiment the thermal conditioner 36 is configured to at least partially compensate for resistive heating of the coils 31.

The thermal conditioner 36 may be configured to cool the coils 31. When the thermal conditioner cools the coils 31, the temperature of the coils 31 may continue to increase, albeit at a lower rate compared to if the thermal conditioner 36 was not provided. Alternatively, the thermal conditioner 36 may substantially maintain the temperature of the coils 31, or reduce the temperature of the coils 31. The thermal conditioner 36 may be configured to maintain the temperature of the coils 31 at a target temperature.

As shown in Figure 9, in an embodiment the thermal conditioner 36 comprises cooling bushes on the outer and inner diameter of the coil unit of the support member 30. For example, the thermal conditioner 36 may comprise one or more thermal conditioning channels for transporting thermal conditioning fluid (e.g. water) close to the coils 31. The temperature of the thermal conditioning fluid may be controlled by the controller so as to control the temperature of the coils 31.

In an embodiment the stage 202 comprises electrical connections for electrically connecting one or more power supplies to the coils 31 so as to control current supply to the coils 31. In an embodiment the stage 202 comprises one or more fluid channels for applying thermal conditioning fluid, for example, to the thermal conditioner 36. By providing that the coils 31 and the thermal conditioner 36 are provided in the support member 30, it is not necessary for the electrical connections and the fluid channels to be rotatable relative to the base frame 12 (or the metrology frame 13) to which the support member 30 is attached. An embodiment of the invention is expected to make it easier to manufacture the stage 202.

In an embodiment the stage 202 is configured such that the movable member 20 is rotatable relative to the support member 30 with an infinite stroke. In other words, the movable member 20 may continuously rotate about the Y axis relative to the support member 30. This allows the stage 202 to substantially continuously place dies 210 from the donor substrate 209 onto the acceptor substrate 220. An embodiment of the invention is expected to increase throughput of die placement.

In case the movable member 20 needs to be rotated about the Y-axis a Lorentz force actuator may be utilized as described previously. In case less than six controllable degrees of freedom are needed a simpler design may be adopted, for example making use of less than 3 groups of coils and/or less (permanent or electromagnetic based) magnetic field generating elements. For example in the case of one additionally required degree of freedom only one magnetic field generating element (typically a permanent magnet) and a coil may be positioned such that a force perpendicular to the rotary motion is generated.

In an embodiment the actuator 10 for the stage 202 is a Lorentz force actuator configured to drive a rotating movement. The actuator comprises a first member comprising a circularly arranged plurality of coils; and a second member that is rotatable relative to the first member and comprising a plurality of magnetic field generating elements arranged substantially concentric with the plurality of coils, characterized in that at least one magnetic field generating element and coil are relatively positioned such to enable force generation in a direction perpendicular to the rotating movement.

In an embodiment the magnetic field generating elements are permanent magnets.

In an embodiment the plurality of coils comprises at least three groups of coils, each group comprising at least three coils arranged such that Lorentz forces are applicable between the coils and the plurality of magnetic field generating elements in at least two degrees of freedom.

In an embodiment the actuator comprises a commutator configured to apply commutations to the coils such that the Lorentz forces in the at least two degrees of freedom are substantially independently controllable.

In an embodiment the groups have substantially fixed positions relative to each other.

In an embodiment the magnetic field generating elements are part of a magnet track that is comprised in the movable member and the coils are comprised in the support member.

In an embodiment the magnet track comprises two series of magnetic field generating elements s on opposing sides of the channel, each series comprising magnetic field generating elements of alternating polarity distanced from each other.

In an embodiment at least one of the plurality of magnetic field generating elements comprises at least one Halbach magnet connecting adjacent magnetic field generating elements.

In an embodiment the actuator comprises magnet supports configured to mechanically support respective magnetic field generative elements.

In an embodiment the magnet supports comprise a magnetic material.

In an embodiment the actuator comprises a thermal conditioner configured to thermally condition the coils.

In an embodiment the actuator comprises a stroke limiter configured to prevent the coils from moving.

Figure 10 schematically depicts a Lorentz force actuator 10 combined with a long stroke actuator 40. As shown in Figure 10, in an embodiment the stage 202 comprises a long stroke actuator 40. The long stroke actuator 40 is configured to actuate a stroke in the Y direction (i.e. the vertical direction in the orientation shown in Figure 10). The Y direction may be referred to as the long stroke direction, i.e. the direction in which the long stroke actuator actuates. In an embodiment the long stroke direction is the direction primarily required for placement of the die 210 onto the acceptor substrate 220. For example Figure 2 schematically shows a die 210C positioned at the bottom of the stage 202. The die 210C is required to be moved in the Y direction in order to position onto the acceptor substrate 220. In an embodiment the stage 202 is configured to have a longer stroke in the Y direction (i.e. the long stroke direction) compared to its stroke in the X direction or the Z direction, for example.

In an embodiment the long stroke actuator 40 is configured, on actuation, to move the support member 30 and the movable member 20 in the long stroke direction. For example, the long stroke actuator 40 may be configured, on actuation, to move the support member 30 and the movable member 20 relative to a frame 50. The frame 50 may be the base frame 12 or the metrology frame 13, for example. As shown in Figure 10, in an embodiment the long stroke actuator 40 comprises a bearing 41 for coupling the support member 30 to the frame 50.

In an embodiment, the stroke of the support member 30 and the movable member 20 in the long stroke direction actuated by the long stroke actuator is longer than the stroke of the movable member 20 relative to the support member 30 in the long stroke direction actuated by the Lorentz force actuator 10. The Lorentz force actuator 10 may be configured to move the movable member 20 in the long stroke direction more accurately than the long stroke actuator 40. The long stroke actuator 40 may be an actuator different from a Lorentz force actuator. The long stroke actuator may be more susceptible to disturbance motions, for example from the frame 50. However, the accurate positioning provided by the Lorentz force actuator 10 suppresses such disturbance motions, albeit over a shorter strip.

In an embodiment the stroke achievable by the long stroke actuator 40 is greater than half of the perpendicular distance between the series of magnets 22 that define the channel. By providing the long stroke actuator, the design freedom of the magnet track may be increased. In particular, it may not be necessary to provide a large space between the movable member 22 and the support member 30 in the Y direction (i.e. the long stroke direction). Accordingly, the magnets 22 may be positioned closer together, thereby increasing the magnetic field strength. Sufficient space may be provided to allow the thermal conditioner 36 to be provided.

Figure 10 schematically shows a long stroke actuator 40 acting in the vertical direction. In an embodiment, a long stroke actuator is provided for moving the support member 30 and the movable member 20 in a horizontal direction (e.g. in the Z direction). Additionally or alternatively, a long stroke actuator may be provided for providing a longer stroke (even if at less accuracy) in one or more other degrees of freedom.

In an embodiment the stage 202 comprises an intermediate long stroke body. The long stroke body may be intermediate between the support member 30 and the frame 50. The long stroke body may be secured to the support member 30. The long stroke body may be considered to be part of the support member 30.

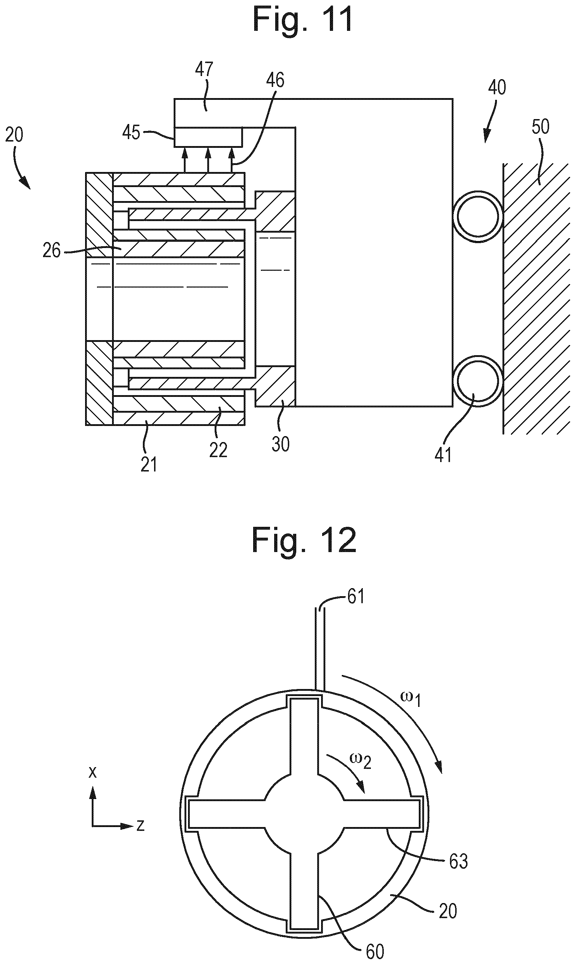

Figure 11 schematically depicts an alternative arrangement of a Lorentz for actuator 10 and a long stroke actuator 40 of a stage 202 for die placement. As shown in Figure 11, in an embodiment the stage 202 comprises a gravity compensator 45. As shown in Figure 11, in an embodiment the gravity compensator 45 comprises a permanent magnet. The gravity compensator may be fixed relative to the support member 30. For example, as shown in Figure 11 in an embodiment the gravity compensator 45 is secured to an arm 47 of the long stroke body. The long stroke body may be secured to the support member 30. Accordingly, the gravity compensator 45 may be fixed relative to the support member 30. The gravity compensator 45 may be configured to compensate for gravity on the movable member 20. The gravity compensator 45 is configured to generate a force for gravity compensation.

The gravity compensator 45 is added to the long stroke to reduce the amount of DC power dissipated for lifting the movable member 20. As shown in Figure 11, the gravity compensator 45 may comprise a permanent magnet. The permanent magnet 45 is configured to generate a magnetic field 46. For example, the gravity compensator 45 may be configured to generate a magnetic field 46 for attracting the first support 21 of the magnet track of the movable member 20. As mentioned elsewhere, in an embodiment the first support 21 comprises a magnetic material. Alternatively, the first support 21 may comprise a non-magnetic material such as a polymer. One or more magnetic elements may be provided, for example on the outer surface of the first support 21 for gravity compensation with the gravity compensator 45.

It is not essential for the gravity compensator 45 to comprise a permanent magnet. In an alternative arrangement, the gravity compensator comprises an electromagnet. The gravity compensator 45 may be fixed relative to the long stroke body. The gravity compensator may also be positioned below the movable member (pushing it upwards).

Figure 12 schematically depicts an optional secondary drive for the stage 202. As shown in Figure 12, in an embodiment the stage 202 comprises a secondary member 60. The secondary member 60 is movable relative to the support member 30. The secondary member 60 is movable relative to the movable member 20. Figure 12 schematically depicts the secondary member 60 and the movable member 20. The movable member 20 may be the movable member 20 depicted in Figure 3, for example. The secondary member 60 shown in Figure 12 may be rotatable about an axis into and out of the plane (i.e. the Y axis).

Figure 12 schematically depicts the secondary member 60 at a first point in time. As shown in Figure 12, in an embodiment the secondary member 60 comprises at least one arm 63. In the arrangement shown in Figure 12, the secondary member 60 comprises four arms 63. However, it is not essential for the secondary member 60 to comprise four contact elements 63. In an alternative arrangement, the secondary member 60 comprises one, two, three or more than four contact members 63.

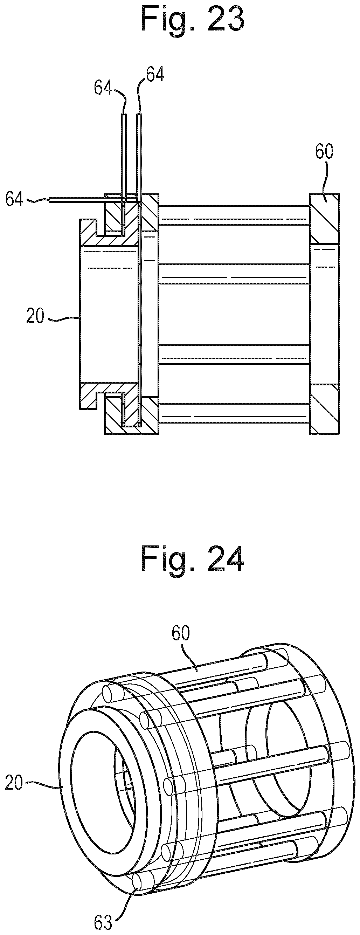

As shown in Figure 12, in an embodiment the secondary member 60 comprises contact members 63 arranged as arms. The arms are protruding radially outwardly from a hub of the secondary member 60. However, it is not essential for the contact members 63 to be formed as radially outward arms. For example, Figure 24 depicts an alternative arrangement in which the contact members 63 are formed as axial rods.

In an embodiment the stage 202 comprises a secondary actuator. The secondary actuator is configured, on actuation, to move the secondary member 60 relative to the support member 30 and/or the movable member 20. The secondary member 60 is configured to controllably contact the movable member 20 so as to apply a force to the movable member 20 during acceleration of the movable member 20 relative to the support member 30. Here, acceleration of the movable member 20 relative to the support member 30 includes negative accelerations, i.e. decelerations.

At the point in time shown in Figure 12, the secondary member 60 is distanced from the movable member 20. The secondary member 60 is not in contact with the movable member 20. A gap 61 is provided between the movable member 20 and the secondary member 60 such that the secondary member 60 applies substantially no force on the movable member 20.

As shown in Figure 12, in an embodiment the secondary member 60 is substantially concentric with the movable member 20. The secondary member 60 and the movable member 20 are configured to rotate about their common central axis, i.e. the Y axis. The movable member 20 is configured to place the dies 210. The secondary member 60 is connected to the secondary actuator, which may be a rotary motor, for example.

As shown in Figure 12, the movable member 20 may have a rotational speed of ω₁. The secondary member 60 has a rotational speed ω₂.

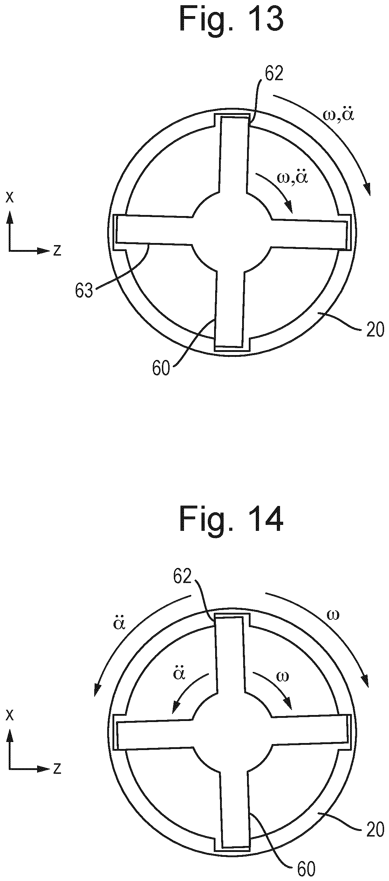

Before acceleration of the movable member 20 relative to the support member 30, the controller is configured to control the secondary member 60 to make a small movement, such that the gap 61 is reduced to zero. When the gap 61 is reduced to zero, the secondary member 60 is controlled to contact the movable member 20 at a contact point 62. Figure 13 schematically shows the point at which the secondary member 60 contacts the movable member 20. When the gap 61 is zero, the movable member 20 starts to accelerate. The secondary member 60 accelerates together with the movable member 20. The acceleration and rotational speed of the secondary member 60 is substantially identical to the acceleration and rotational speed of the movable member 20.

In an embodiment, after acceleration the movable member 20 is set to have a substantially constant rotational speed. The secondary member 60 may be controlled so as to separate from the movable member 20, i.e. to increase the gap 61 to a non-zero value. When the movable member 20 is to be decelerated relative to the support member 30, the secondary member 60 may be controlled to help deceleration. Figure 14 shows the point at which the secondary member 60 is moved relative to the movable member 20 so as to contact the movable member 20 at the contact point 62. The acceleration is in the opposite direction from the rotational speed, i.e. the acceleration is a deceleration.

When the movable member 20 is at rest relative to the support member 30, the secondary member 60 is decoupled from the movable member 20. The stage 202 can be controlled to place a die 210 with high accuracy from the movable member 20.

In an embodiment the secondary member 60 is configured to apply the force to the movable member 20 in the direction of the acceleration. This is in the opposite direction in Figure 13 compared to in Figure 14 (deceleration). As shown in Figure 12, the secondary member 60 may be configured to be distanced from the movable member 20 during substantially constant motion of the movable member 20 relative to the support member 30.

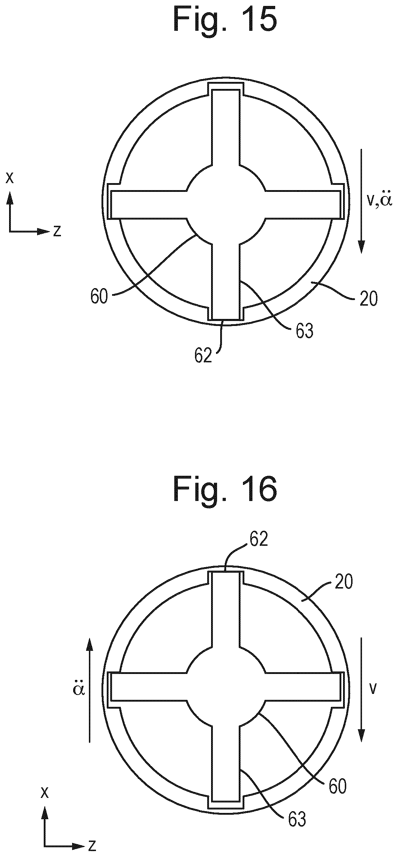

In an embodiment, the secondary member 60 is configured to controllably contact the movable member 20 so as to apply a force to the movable member 20 during acceleration (or deceleration) of the movable member 20 relative to the support member 30 in at least two degrees of freedom. The degree of freedom illustrated in Figure 12, Figure 13 and Figure 14, for example, is rotation about the Y axis. Figure 15 and Figure 16 show the degree of freedom of translation along the X axis (i.e. vertical motion). Figure 15 shows the secondary member 60 contacting the movable member 20 at the contact point 62 so as to aid with acceleration in the X direction. The secondary member 60 may be configured to impart forces on the movable member 20 for linear movement in addition to for rotational movement.

Figure 16 schematically depicts the secondary member 60 imparting a force on the movable member 20 via the contact point 62 for deceleration of the movable member 20 in the X direction (i.e. the vertical direction).

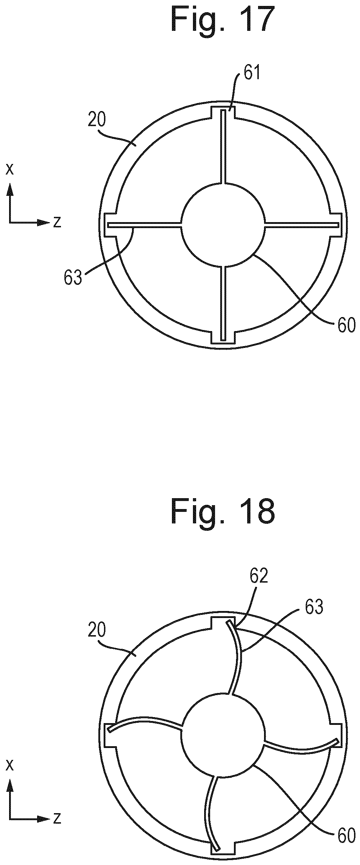

Figure 17 schematically depicts an alternative secondary member 60. As shown in Figure 17, the contact member 63 may be provided to have lower contact stiffness with respect to the movable member 20. Figure 17 shows the secondary member 16 with a gap 61 relative to the movable member 20 such that the contact members 63 do not contact the movable member 20. Figure 18 shows a different point in time in which the contact elements 63 of the secondary member 60 contact the movable member 20 at the contact point 62. As shown in Figure 18, in an embodiment the contact elements 63 are configured to flex when the contact elements 63 come into contact with the movable member 20. The contact elements 63 may be provided as flexible members configured to flex when the secondary member 60 contacts the movable member 20.

By allowing the contact elements 63 to flex, the contact stiffness of the secondary member 60 on the movable member 20 may be reduced. This may reduce forces which may otherwise reduce the accuracy of positioning of the movable member 20 relative to the support member 30.

Additionally or alternatively, the impact velocity of the secondary member 60 relative to the movable member 20 may be reduced.

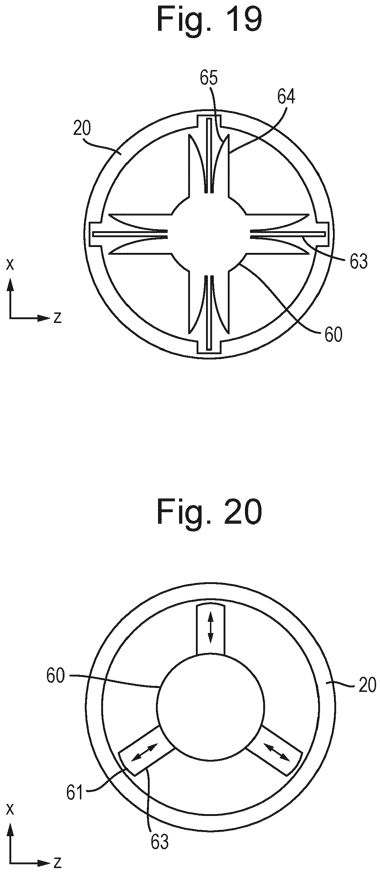

Figure 19 schematically depicts an alternative secondary member 60. As shown in Figure 19, the secondary member 60 may be configured such that the flexible member (i.e. the contact element 63) has a stiffness dependent on a position of the secondary member 60 relative to the movable member 20. In the example shown in Figure 19, the contact element 63 is provided as a spring with progressive stiffness. The contact elements 63 may be formed as mechanical springs. The geometry of the mechanical springs may change as a function of the stroke, i.e. the position of the secondary member 60 relative to the movable member 20.

In the example shown in Figure 19, the contact elements 63 are formed as leaf springs. The leaf springs 63 may be bent over a predefined surface so as to have progressive stiffness. In other words, the stiffness of the contact element 63 increases as a secondary member 60 is moved further in the direction that causes contact with the movable member 20.

As shown in Figure 19, in an embodiment the secondary member 60 comprises a stiffness element 64. The stiffness element 64 comprises a predefined surface 65 configured to cause the stiffness of the contact element 63 to increase as the contact element 63 is moved into the movable member 20. As shown in Figure 19, in an embodiment each contact element 63 has two associated stiffness elements 64, one for each direction of rotation. Each stiffness element 64 has a corresponding predefined surface facing the corresponding contact element 65.

It is not essential for the progressive stiffness to be effected by a mechanical spring with changing geometry as a function of stroke. In an alternative arrangement, the secondary member 60 comprises an air spring. The air spring may comprise a closed pneumatic volume that is compressed upon contact between the secondary member 60 and the movable member 20. The compression causes the stiffness to increase.

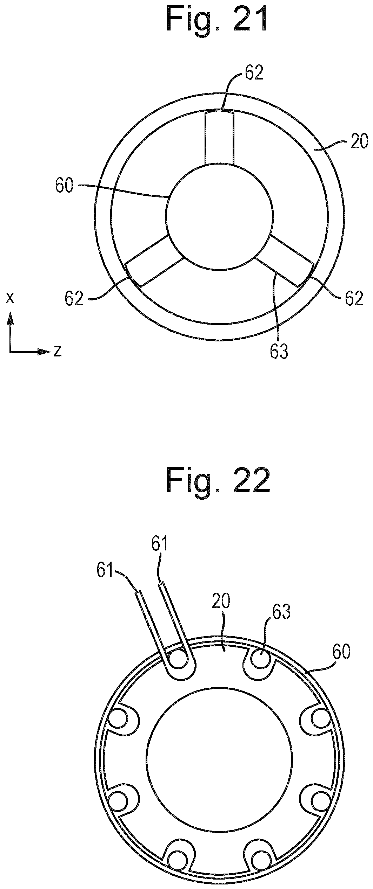

Figure 20 schematically depicts an alternative secondary member 60. As shown in Figure 20, in an embodiment the secondary member 60 comprises at least one active element configured to generate contact with the movable member 20 during acceleration or deceleration of the movable member 20 relative to the support member 30. As shown in Figure 20, in an embodiment the contact elements 63 are formed as clamps configured to clamp to the movable member 20. Figure 20 shows the contact elements 63 in the unclamped position. Figure 21 schematically shows the contact elements 63 in the clamped position, such that the contact elements 63 make contact with the movable member 20 at the contact points 62.

In an embodiment the contact elements 63 comprise a pneumatic clamp for clamping to the movable member 20. The controller may be configured to control the pneumatic clamp to clamp the secondary member 60 to the movable member 20 during acceleration phases.

In an alternative arrangement, the contact elements 63 comprise piezoelectric clamps. For example, the controller may be configured to control an electric potential applied to the contact elements 63 so as to cause the contact elements 63 to change shape so as to clamp to the movable member 20.

Clamping may be effected when it is desired to use the secondary member 60 to help the overall member 20 to accelerate or decelerate relative to the support member 30. The secondary member 60 may be unclamped from the movable member 20 when a substantially constant rotational speed of the movable member 20 relative to the support member 30 is desired.

Figure 22 is a schematic view of an alternative secondary member 60. Figure 23 is a side on view of the secondary member 60. Figure 24 is a perspective view of the secondary member 60 relative to the movable member 20.

As shown in Figure 22, in an embodiment the contact elements 63 comprise axial rods. The axial rods may extend substantially parallel to the primary axis of the Lorentz force actuator 10, for example the Y axis. The ends of the axial rods, i.e. the contact elements 63 may be configured to contact the movable member 20 during acceleration or deceleration phases. Figure 22 shows the point in time at which the contact elements 63 are distanced from the movable member 20 by gaps 61.

During acceleration or deceleration phases, the secondary member 60 may be controlled to move relative to the movable member 20 so that one of the gaps 61 is reduced to zero. In an embodiment, the axial rods that form the contact elements 63 may be compliant, so as to reduce impact forces on the movable member 20. This may help to increase the accuracy with which the movements of the movable member 20 can be controlled.

As shown in Figure 23, in an embodiment the secondary member 60 may be arranged relative to the movable member 20 such that there are further gaps 64 in the Y direction and in the X or Z directions. These further gaps 64 may be for allowing movement of the movable member 20 relative to the support member 30 in the five degrees of freedom (in addition to the rotation about the Y axis). In an embodiment the stage 202 comprises a stroke limiter. The stroke limiter is configured to prevent the coils 31 from moving out of the channel. For example, as shown in Figure 23, the secondary member 60 may be configured to provide the stroke limiter. The stroke limiter may be configured to prevent the movable member 20 from separating completely away from the support member 30 such that the position of the movable member 20 can no longer be controlled.

The stroke limiter is configured to reduce possible damage to the stage 202. In particular, the stroke limiter may help to reduce damage to dynamic link hoses (e.g. for the thermal conditioner) and/or cables (e.g. for applying electric potentials to the coils 31 or the die acceptors 216). In an embodiment the stroke limiter is configured to limit the strokes in all six degrees of freedom.

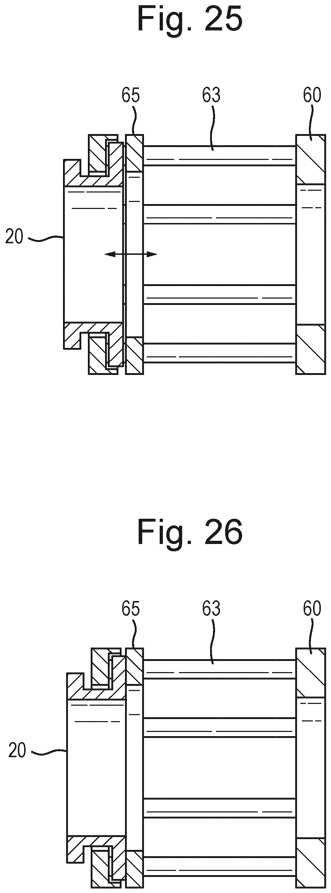

Figure 25 is a schematic view of an alternative secondary member 60. Figure 25 is a view of the secondary member 60 in an unclamped position. Figure 26 is a perspective view of the secondary member 60 in a clamped position. The secondary member 60 of Figure 25 forms an axial clamp. The active clamp can be actuated by a piezoelectric device or by a pneumatic device, for example.

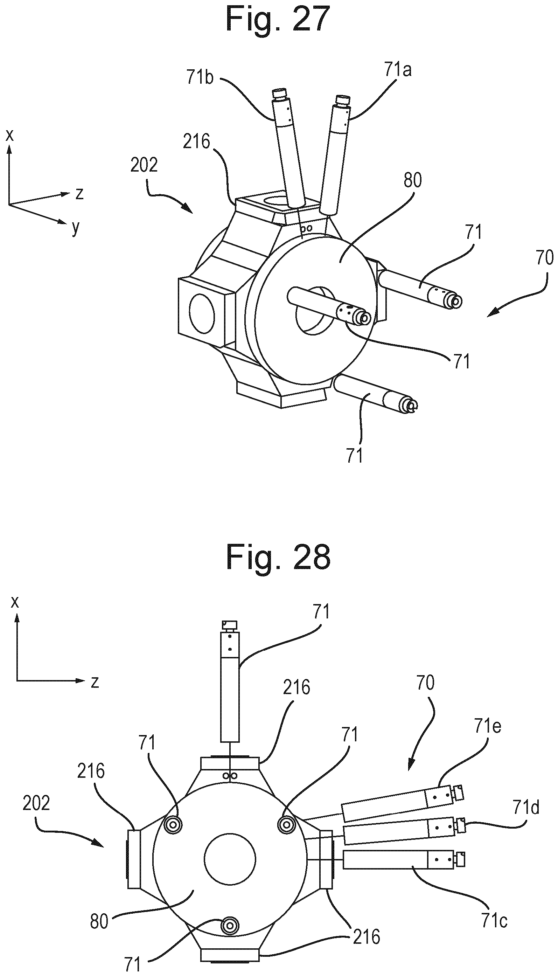

Figure 27 schematically depicts the stage 202 together with a measurement system 70. In an embodiment the bonding tool comprises a measurement system 70. The measurement system 70 is configured to measure a position of the movable member 20. For example, the measurement system 70 may be configured to measure the position of the movable member 20 relative to the metrology frame 13. In an embodiment the measurement system 70 is configured to measure the position of one or more of the die acceptors 216 of the stage 202. In an embodiment the measurement system 70 is configured to measure position in at least three degrees of freedom, optionally in at least 4 degrees of freedom, optionally in at least five degrees of freedom and optionally in six degrees of freedom. The six degrees of freedom may be translational movements along each of the X, Y and Z axes, as well as rotational movements about each of the X, Y and Z axes.

In an embodiment the bonding tool comprises a controller. The controller may be configured to control the position of the stage 202. For example, the controller may be configured to position the movable member 20 of the stage 202 in six degrees of freedom. By providing the measurement system 70, the measurement system 70 may output measurement signals to the controller. In an embodiment the controller is configured to control the position of the movable member 20 based on measurement signals received from the measurement system 70.

In an embodiment the measurement system 70 is configured to measure the position of at least one of the die acceptors 216 during rotation of the movable member 20 relative to the support member 30. For example, the movable member 20 may rotate about the Y axis relative to the support member 30. In an embodiment during rotation the measurement system 70 is configured to measure the position to a first level of accuracy. In an embodiment the measurement system 70 is configured to measure the position of at least one of the die acceptors 216 during placement of a die 210 onto the acceptor substrate 220 to a second level of accuracy. In an embodiment the second level of accuracy is greater than the first level of accuracy.

For example, for a die bonding application the position of one or more of the die acceptors 216 during placement may be required to be known to a particularly high degree of accuracy. Meanwhile, during a rotation of the movable member 20 (for example between placement of sequential dies 210), the position of the die acceptors 216 may not need to be known to such a high level of accuracy. By providing two levels of accuracy for measurement at different time periods, the requirements on the design of the measurement system 70 may be relaxed, without unduly affecting the required level of accuracy of measurement.

It is not essential for two different levels of accuracy to be used for different time periods. In an alternative embodiment, the second level of accuracy is substantially the same as the first level of accuracy.

As shown in Figure 27, in an embodiment the measurement system 70 comprises a plurality of measurement sensors 71. In an embodiment each measurement sensor 71 comprises an interferometer. Additionally or alternatively, one or more of the measurement sensors 71 may comprise a capacitive sensor and/or an inductive sensor.

As shown in Figure 27, in an embodiment three measurement sensors 71 are configured to measure a measurement surface 80 of the stage 202. In an embodiment the stage 202 comprises the measurement surface 80. The measurement surface 80 may be substantially planar, i.e. flat. In an embodiment the stage 202 comprises a disc, for example a flat disc that has the measurement surface 80 as an exterior surface. In an embodiment the movable member 20 of the stage 202 comprises the measurement surface 80. Each of the three measurement sensors 71 may be configured to measure a distance to the measurement surface 80. As the movable member 20 changes position, the change in position may be monitored by the measurement sensors 71 that measure the measurement surface 80.

In an embodiment the three measurement sensors 71 that measure the measurement surface 80 are configured to measure the position of the movable member 20 in three degrees of freedom. The three degrees of freedom may be translational motion along the Y axis, rotational motion around the Z axis and rotational motion around the X axis.

As shown in Figure 27, in an embodiment the measurement system 70 comprises at least one measurement sensor 71a, 71b configured to measure a position of the movable member 20 in the X axis (which may be the vertical direction). Figure 27 schematically depicts two measurement sensors 71a, 71b configured to measure the X position. In an alternative embodiment, only one measurement sensor 71 may be provided to measure the X position of the movable member 20 of the stage 202.

As shown in the arrangement of Figure 27, in an embodiment a plurality of measurement sensors 71a, 71b are configured to measure the X position of the movable member 20. By providing a plurality of measurement sensors 71a, 71b, the X position of the movable member 20 may be measured over a larger range of motion of the movable member in the X direction. For example, it may be that during use of the stage 202, the vertical stroke (X) is larger than the measurement stroke of a single measurement sensor 71. By providing one or more additional measurement sensors, the total measurement stroke of the plurality of measurement sensors 71a, 71b may be increased.

As shown in Figure 27, in an embodiment the measurement sensors 71a, 71b are located at different positions along the X direction, namely the direction in which the measurement sensors 71a, 71b are configured to measure motion of the movable member 20.

In an embodiment, the measurement ranges of the individual measurement sensors 71a, 71b overlap each other. In an embodiment the controller is configured to receive measurement signals from the plurality of measurement sensors 71a, 71b. The controller may be configured to switch between measurement signals from different measurement sensors 71a, 71b during motion along the X direction of the movable member 20.

In an embodiment, different types of measurement sensor are provided to measure the X position at different positions of the movable member 20 along the X direction. For example, in an embodiment a first measurement sensor is configured to measure the position when the movable member 20 is at the top of its range of movement along the X direction (i.e. when it is vertically highest). The measurement sensor is not required to have a large measurement stroke. For example, the measurement sensor may be an interferometer probe or an eddy current sensor. The measurement sensor may be configured to provide accurate measurement during placement of a die 210 on the top of the stage 202.

In an embodiment a second measurement sensor is provided to measure the X position during vertical movement of the movable member 20 from the top of its stroke range to the bottom of its stroke range. During vertical movements, the vertical position may not be required to be known as accurately. The second measurement sensor may be, for example, a laser triangulation sensor.

In an embodiment a third measurement sensor is provided to measure the position when the movable member 20 is at the bottom of its range of positions along the X direction. The third measurement sensor may be, for example, an interferometer probe or an eddy current sensor. The third measurement sensor may be configured to provide accurate measurement of the X position during placement of a die 210 onto the acceptor substrate 220.

Figure 28 schematically depicts a modified version of the measurement system 70 shown in Figure 27. As shown in Figure 28, in an embodiment the measurement system 70 comprises at least one measurement sensor 71c, 71d, 71e configured to measure the position of the movable member 20 in the Z direction (i.e. movements lateral to the rotational axis of the stage 202). The arrangement shown in Figure 28 comprises three measurement sensors 71c, 71d, 71e. In an alternative arrangement, a single measurement sensor 71 is provided to measure the Z position of the movable member 20.

As shown in Figure 28, in an embodiment a plurality of measurement sensors 71c, 71d, 71e are provided to measure the Z position of the movable member 20. By providing a plurality of measurement sensors 71c, 71d, 71e, the Z position may be measured more accurately.

For example, as shown in Figure 28, in an embodiment the measurement sensors 71c, 71d, 71e are configured to measure the minor surface of the flat disc that comprises the measurement surface 80. The measuring angle of the surface may be limited. In particular, when the measurement sensor 71 is directed towards a surface that is substantially normal to the direction of view of the measurement sensor 71, then a good quality measurement may be made. However, when the surface being measured is at a different angle relative to the direction of view of a measurement sensor, then the quality of the measurement made may reduce. As the movable member 20 moves up and down, the angle of the measured surface at the edge of the flat disc may vary with respect to the direction of view of a single measurement sensor 71. By providing a plurality of measurement sensors 71c, 71d, 71e, the quality of the measurement of the Z position may be improved over a larger range of X positions of the movable member 20.

A large vertical stroke of the movable member 20 leads to relatively large angles (away from the ideal of a normal surface being measured). By providing a plurality of measurement sensors 71, the measurement sensors 71c, 71d, 71e may have different capturing ranges. This may help to deal with the vertical stroke of the movable member 20.

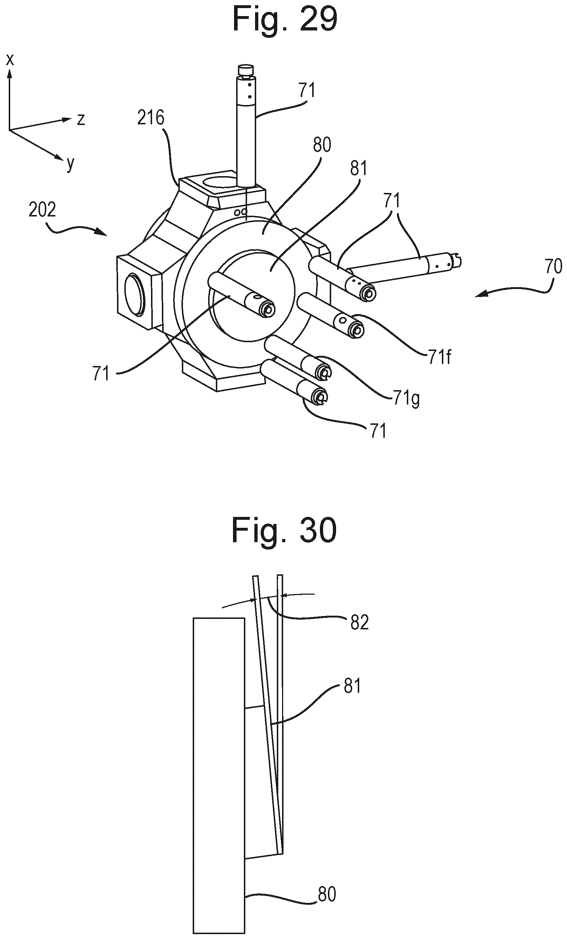

Figure 29 schematically depicts an alternative stage 202. As shown in Figure 29, in an embodiment the stage 202 comprises an angle measurement surface 81. The angle measurement surface 81 may be tilted relative to a plane perpendicular to an axis of rotation of the movable member 20 relative to the support member 30.

Figure 30 is a diagram illustrating the angle measurement surface 81. As shown in Figure 30, the angle measurement surface 81 is tilted relative to a plane perpendicular to the axis of rotation. The axis of rotation may be the Y axis. In contrast, the measurement surface 80 is substantially perpendicular to the axis of rotation. In an embodiment a tilt angle 82 is provided between the angle measurement surface 81 and the measurement surface 80. The tilt angle 82 may be at most 10 degrees, optionally at most 5 degrees, optionally at most 2 degrees and optionally at most 1 degree. In an embodiment the tilt angle 82 is at least 0.1 degrees, optionally at least 0.2 degrees, optionally at least 0.5 degrees, and optionally at least 1 degree.

By providing the tilted angle measurement surface 81, the rotational angle (i.e. rotation about the Y axis) can be measured. As shown in Figure 29, in an embodiment a plurality of measurement sensors 71f, 71g are configured to measure the angle measurement surface 81 so as to measure the angle of rotation of the movable member 20. The angle may be measured while the movable member 20 is rotated to the next die station. The die station may correspond to the position of a die acceptor 216. The movable member 20 may rotate between die stations so as to receive or deposit sequential dies 210.

By providing the plurality of measurement sensors 71f, 71g, the angle of rotation may be determined based on the difference in measurements made by the measurement sensors 71f, 71g. During rotation of the movable member 20 it may not be necessary to measure the rotation angle to a particularly high level of accuracy.

In the arrangement shown in Figure 29, a plurality of measurement sensors 71f, 71g are provided for measuring the angle measurement surface 81. In an alternative embodiment, only one measurement sensor 71 is provided to measure the angle measurement surface 81. When only one measurement sensor 71 is provided, then the degree of rotation may be determined but it may not be possible to measure the direction (e.g. clockwise versus anticlockwise) of the rotation. By providing a plurality of measurement sensors 71f, 71g, both the degree of rotation and the direction of rotation may be determined.

In an embodiment the measurement sensors 71f, 71g are interferometric probes. Alternatively, the measurement sensors 71f, 71g may be of a different type, for example a laser triangulation sensor.

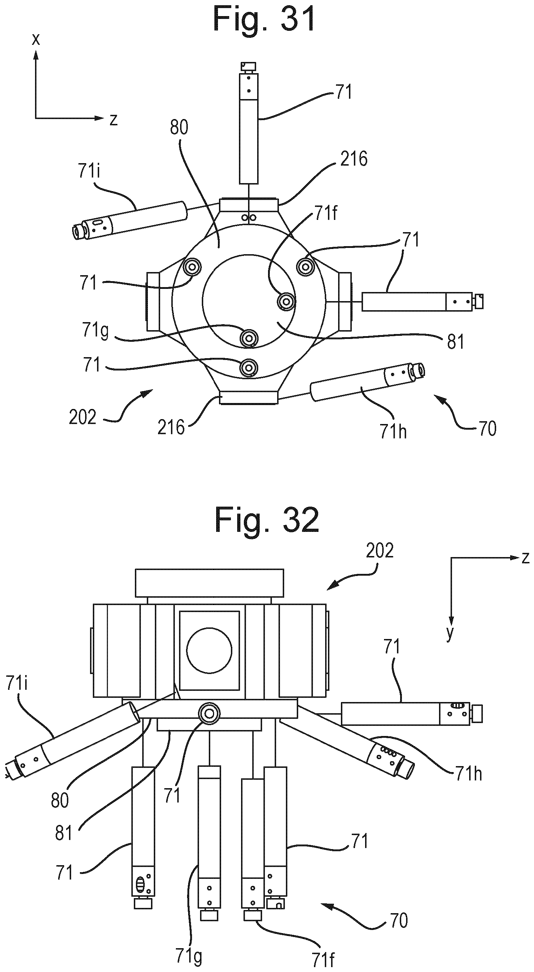

Figure 31 is a schematic view of an alternative measurement system 70. As shown in Figure 31, one or more additional measurement sensors 71h, 71i may be provided to measure the Z position of the movable member 20. In particular, the additional measurement sensors 71h, 71i may be configured to measure the Z position when the movable member 20 is substantially stationary. For example, the Z position may be measured by the one or more additional measurement sensors 71h, 71i during pick-up of a die 210 by the stage 202, during alignment of the movable member 20 and/or during depositing of a die 210 onto the acceptor substrate 220.

As shown in Figure 31, the additional measurement sensors 71h, 71i may be positioned close to the top and the bottom of the movable member 20. Although two additional measurement sensors 71h, 71i are shown in Figure 31, in an alternative embodiment only one additional measurement sensor 71h is provided to measure the Z position at standstill. For example, the measurement sensor 71 close to the bottom of the movable member 20 may be provided. The other additional measurement sensor 71i may be omitted. However, by providing a plurality of additional measurement sensors 71h, 71i, the Z position may be measured more accurately.

Figure 32 schematically depicts an alternative view of the measurement system 70 shown in Figure 31. As shown in Figure 32, in an embodiment the additional measurement sensors 71h, 71i are directed at an angle relative to the Y axis and the Z axis.

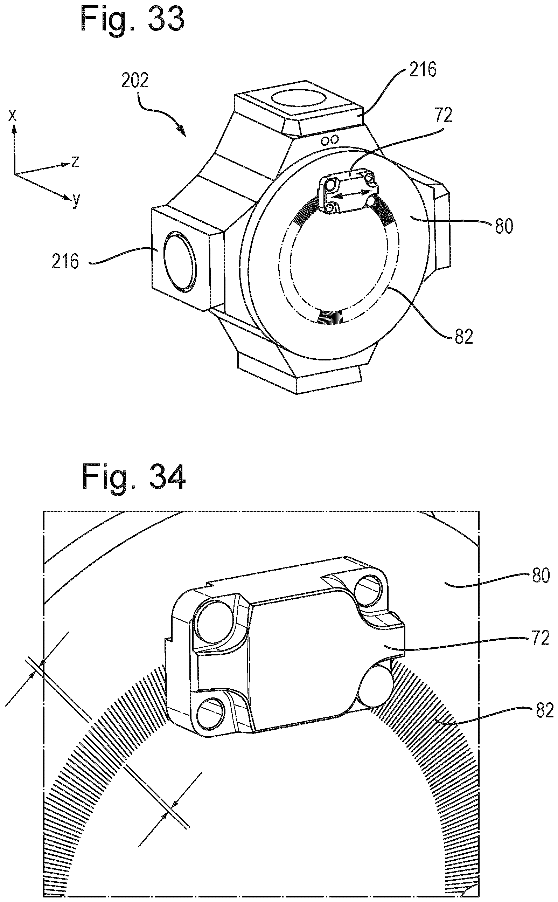

Figure 33 depicts an alternative stage 202. As shown in Figure 33, in an embodiment the stage 202 comprises an angle measurement grating 82. The angle measurement grating 82 may have a pattern that is radial relative to the axis of rotation of the movable member 20 relative to the support member 30. For example, the angle measurement grating 82 may have a pattern that is radial relative to the Y axis in Figure 33.

Figure 34 is an enlarged view of part of the stage 202 shown in Figure 33. The radial pattern can be seen more clearly in Figure 34. The angle of rotation of the movable member 20 can be determined by measuring the angle measurement grating 82.

As shown in Figure 33, in an embodiment the measurement system 70 comprises an encoder head 72. The encoder head 72 is configured to measure the angle measurement grating 82. In an embodiment the encoder head is a one-dimensional encoder head. The encoder head 72 is configured to measure a grating in one-dimension. This dimensionality is shown by the double ended arrow in Figure 33.

As can be seen in Figure 34, the pitch between lines of the angle measurement grating 82 varies as a function of radius. At the radially outer part of the angle measurement grating 82, the pitch is larger. At the radially inward part of the angle measurement grating 82, the pitch is smaller.

In the arrangement shown in Figure 33 and Figure 34, the measurement direction is the lateral direction, as indicated by the double ended arrow in Figure 33, for example. As a result of the pitch deviation, the measurement stroke perpendicular to the measurement direction is limited. That is, if the pitch deviation is too large, then the encoder head 72 may no longer be able to measure the angle measurement grating 82 accurately.

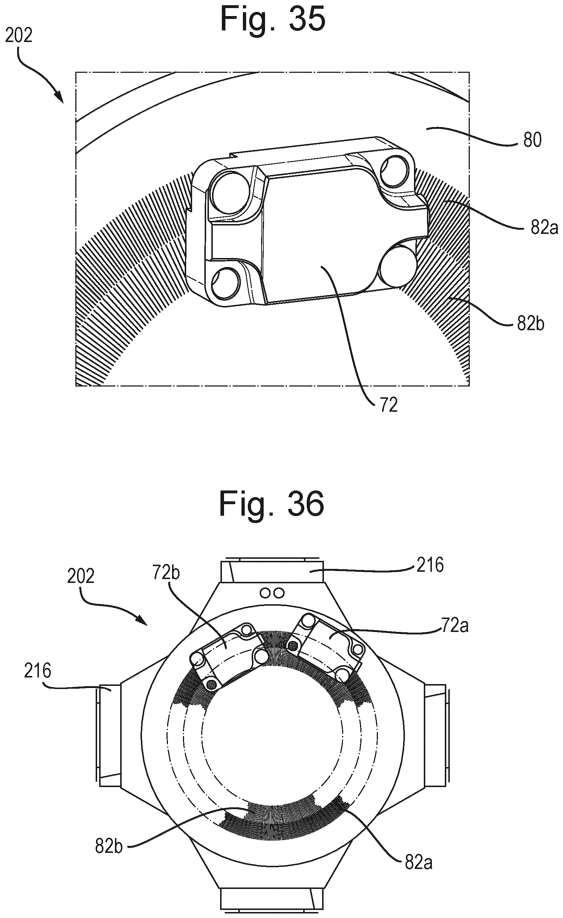

Figure 35 schematically depicts an alternative arrangement. As shown in Figure 35, in an embodiment the stage 202 comprises a plurality of angle measurement gratings 82a, 82b. As shown in Figure 35, the angle measurement gratings 82a, 82b may be located at different radial positions. By providing a plurality of angle measurement gratings 82a, 82b, the problem of the pitch deviation may be overcome. In particular, the pitch deviation across the combined radial size of the angle measurement gratings 82a, 82b may be reduced compared to if only a single angle measurement grating 82 were provided.

By providing multiple radial patterns, the lateral measurement stroke can be enlarged. Figure 35 schematically depicts two angle measurement gratings 82a, 82b. in an alternative embodiment, three or more angle measurement gratings 82 may be provided.

Figure 36 schematically depicts a measurement system 70 comprising a plurality of encoder heads 72a, 72b. By providing a plurality of encoder heads 72a, 72b, the encoder heads 72a, 72b may be configured to measure respective angle measurement gratings 82a, 82b of the stage 202.

In an embodiment, the encoder heads 72a, 72b are configured to output measurement signals to the controller. In an embodiment the controller is configured to switch between measurement signals from the different encoder heads 72a, 72b. This may help to improve the quality of the measurement.

However, it is not essential for a plurality of encoder heads 72a, 72b to be provided. As shown in Figure 35, in an alternative embodiment a single encoder head 72 is provided. The encoder head 72 may, during use, switch from measuring one angle measurement grating 82a to another angle measurement grating 82b. Cy providing additional encoder heads 72a, 72b, the possibility of the measurement data becoming inconsistent when switching between angle measurement gratings 82a, 82b may be reduced.

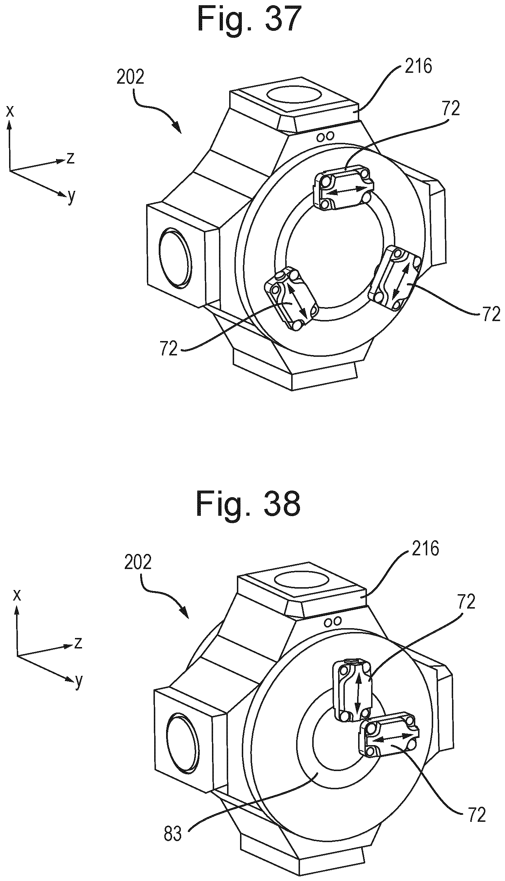

Figure 37 schematically depicts an alternative measurement system 70 for the stage 202. As shown in Figure 37, in an embodiment a plurality of encoder heads 72 are provided to measure the same angle measurement grating 82. By providing multiple encoder heads 72 and the angle measurement grating 82 with a radial pattern, the position in additional degrees of freedom can be measured.

As shown in Figure 37, in an embodiment three encoder heads 72 are provided to measure the angle measurement grating 82. By providing the three encoder heads 72, the position of the movable member 20 can be measured in three degrees of freedom. The three degrees of freedom may be rotation about the Y axis, translation along the Z axis and translation along the X axis.

Figure 38 schematically depicts an alternative stage 202. As shown in Figure 38, in an embodiment the stage 202 comprises a translation measurement grating 83. A translation measurement grating 83 may have a pattern that is circumferential relative to an axis of rotation of the movable member 20 relative to the support member 30. For example, in the orientation shown in Figure 38, the pattern may be circumferential relative to the Y axis. Translational movement of the movable member 20 can be determined by measuring the translation measurement grating 83.

As shown in Figure 38, in an embodiment a plurality of encoder heads 72 are provided in the measurement system 724. The encoder heads 72 are configured to measure the translation measurement grating 83. In an embodiment the encoder heads 72 are configured to determine the position of the movable member 20 along the Z axis and/or along the X axis. Although two encoder heads 72 are shown in Figure 38, in an alternative embodiment a single encoder head 72 may be provided. For example, it may be required only to determine the position in the Z axis or in the X axis by the encoder head 72.

In an embodiment, the encoder heads 72 are not required to have such a high level of position accuracy. However, in principle the position accuracy during rotation can be less compared to the position accuracy required during standstill. As explained elsewhere, additional measurement sensors may be provided for higher accuracy during standstill.

In an embodiment the gratings and their patterns mentioned above can be machined on the flat disc that comprises the measurement surface 80. For example, the patterns may be etched onto the disc.

In an embodiment the translation measurement grating 83 comprises circles of different radii at the same axial position along the axis of rotation. That is, the translation measurement grating 83 is provided on a plane that is substantially normal to the Y axis.

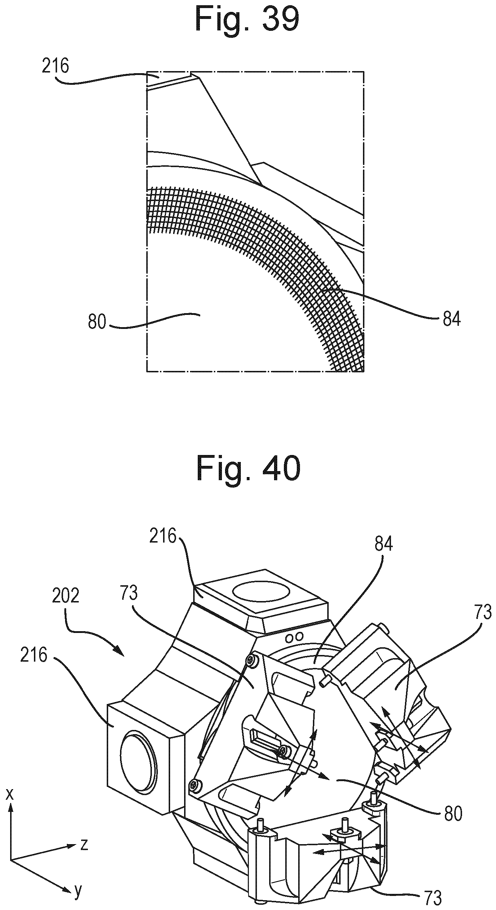

Figure 39 schematically depicts an alternative grating. In particular, as shown in Figure 39, the stage 202 may comprise a combined grating 84. The combined grating 84 may have a two-dimensional pattern. The two-dimensional pattern may be referred to as a checker board pattern. The combined grating 84 may be a combination of the angle measurement grating 82 (with its radial pattern) and the translation measurement grating 83 (with its circumferential pattern). By providing a two-dimensional pattern in the form of the combined grating 84, two dimensional sensors may be used to measure displacement in two degrees of freedom. Figure 40 schematically depicts an alternative measurement system 70. As shown in Figure 40, in an embodiment the measurement system 70 comprises at least one two-dimensional sensor 73. Each two-dimensional sensor 73 is configured to measure the combined grating 84. For example, Figure 40 shows that there may be three two-dimensional sensors 73.

By providing two-dimensional sensors 73, each two-dimensional sensor 73 may measure the Y position and the tangential displacement. By providing three two-dimensional sensors 73, the position of the movable member 20 may be determined in six degrees of freedom at a high accuracy, even during rotation of the movable member 20.

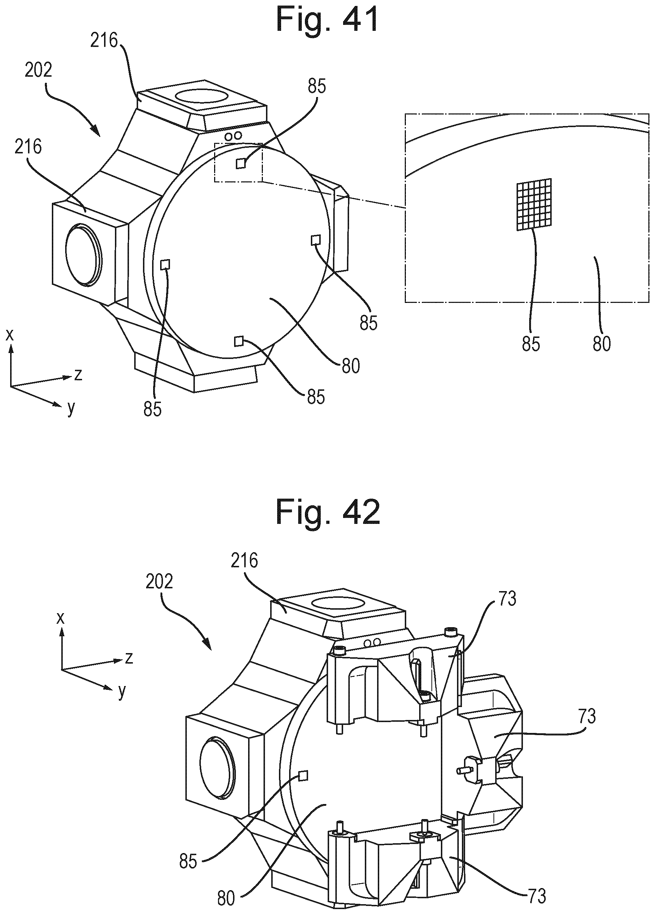

Figure 41 schematically depicts an alternative stage 202. As shown in Figure 41, in an embodiment the stage 202 comprises a plurality of rectangular gratings 85. As shown in Figure 41, the rectangular gratings 85 may be adjacent to respective locations of the stage 202 where a die 210 can be held. For example, the rectangular gratings 85 may be located adjacent to respective die acceptors 216 (which may be referred to as die stations). The rectangular gratings 85 may be located at a plurality of discrete positions of the stage 202. For example, the rectangular gratings 85 may be located on the measurement surface 80 of the stage 202. The measurement surface 80 may substantially face in the Y direction.

By providing rectangular gratings, the issues to do with pitch variation may be resolved. By providing the rectangular gratings, the checker board pattern is substantially square. This might increase the extent to which the two-dimensional sensors 73 are usable and provide accurate measurements.

Figure 42 schematically depicts an alternative stage 202. As shown in Figure 42, in an embodiment three two-dimensional sensors 73 are provided in the measurement system 70. In an embodiment each two-dimensional sensor 73 is configured to measure a respective rectangular grating 85.

As a result of the rectangular gratings 85 being provided at discrete locations, the measurement signals may be loss during rotation, when the two-dimensional sensors 73 cannot measure the gratings 85. During rotation, other measurement sensors can be used to measure the position of the movable member 20.

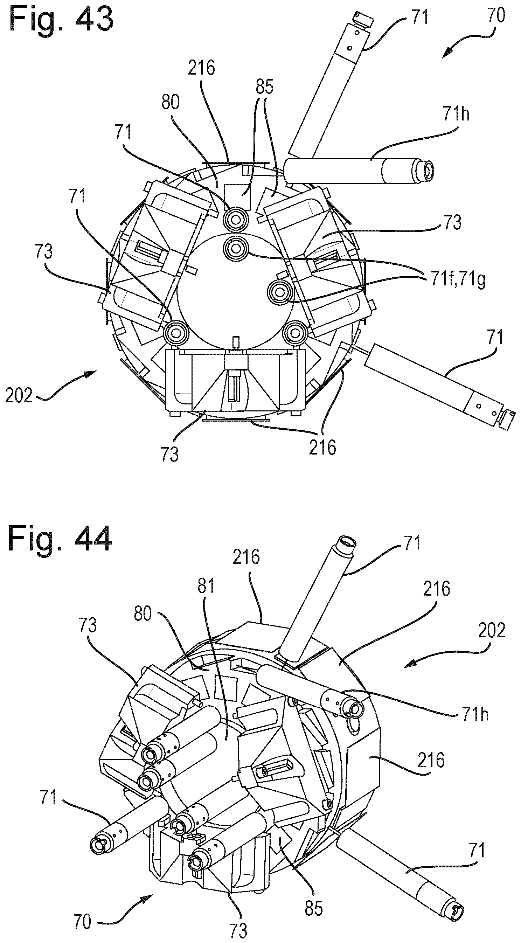

Figure 43 and Figure 44 schematically depict an alternative measurement system 70. As shown in Figure 43, measurement systems described elsewhere may be combined with each other. In the arrangement shown in Figure 43, a rectangular grating 85 is provided at every die station. In the arrangement shown in Figure 43, there are eight die stations, i.e. eight die acceptors 216. The rectangular gratings 85 may be square.

As shown in Figure 43, in an embodiment additional rectangular gratings 85 are located in between die stations. The rectangular grids 85 located between die stations may be used for calibration purposes. Alternatively, the rectangular gratings 85 between die stations may be omitted.

As shown in Figure 43, in an embodiment the measurement system comprises a plurality of two-dimensional sensors 73. The two-dimensional sensors 73 are configured to measure the position in six degrees of freedom, for example during standstill of the movable member 20.

As shown in Figure 43, in an embodiment the measurement system 70 comprises two measurement sensors 71f, 71g configured to measure the rotational angle during rotation. The measurement sensors 71f, 71g are configured to measure the angle measurement surface 81 of the stage 202.

As shown in Figure 43, in an embodiment the measurement system 70 comprises three measurement sensors 71 configured to measure the measurement surface 80. By providing three measurement sensors 71 to measure the measurement surface 80, the translational motion along the Y axis, as well as rotational motion about the X axis and the Z axis may be determined.

As shown in Figure 43, in an embodiment the measurement system 70 comprises two measurement sensors 71 configured to measure the X position and the Z position during rotation and during standstill of the movable member 20. These measurement sensors 71 are shown at the top of Figure 43 and in the bottom righthand corner of Figure 43.

As shown in Figure 43, in an embodiment an additional measurement sensor 71h is configured to determine the rotational position about the Y axis during standstill of the movable member 20. For example, the measurement sensor 71h may be configured to measure the rotational position at every die station of the stage 202.

Figure 44 depicts a perspective view of the measurement system 70 shown in Figure 43.

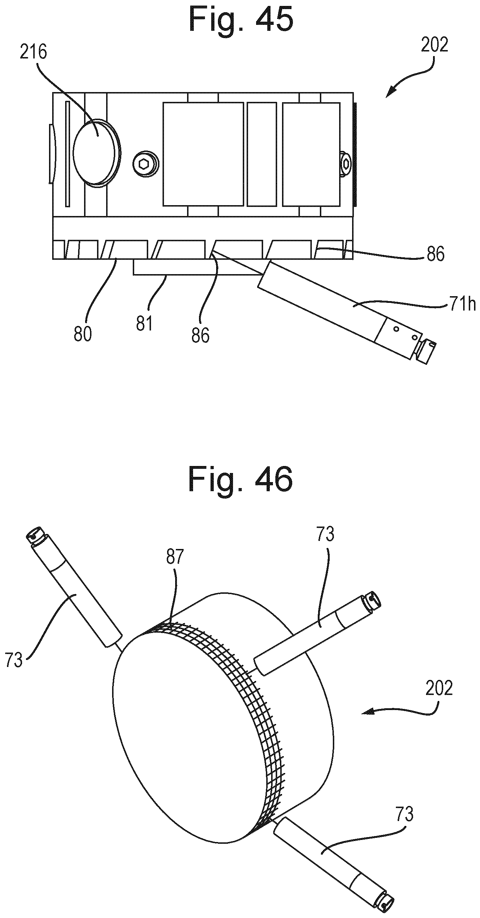

Figure 45 schematically depicts surfaces under an angle 86 that are measured by the additional measurement sensor 71h that is used to determine the rotational position at standstill. As shown in Figure 45, surfaces under an angle 86 may be provided at discrete positions circumferentially around the movable member 20. The surfaces under an angle 86 may be angled relative to the Y axis, i.e. the rotational axis of the movable member 20. This may help to improve the accuracy of the measurements.

In an embodiment the movable member 20 comprises a stable body. In an embodiment substantially all measurement and calibration targets (e.g. gratings and measurement surfaces) are provided on a very stable body. Here, a stable body means a body that does not deform much as a result of changes in temperature. The stable body comprises a material with a particularly low coefficient of thermal expansion. For example, the material may comprise Zerodur or an ultralow expansion glass.

In an embodiment the movable member 20 comprises a stable body that is mounted on the magnet tracks (the magnet yoke) of the stage 202. For example, flexures such as leaf springs may be provided to mount the stable body onto the magnet yoke. During use, the temperature of the magnet yoke may vary. This may cause the magnet yoke to expand or contract. In an embodiment the stable body is arranged so as to deform much less than the magnet yoke. In an embodiment the stage 202 is configured such that the centre of both the stable body and the magnet yoke remain in the same position during changes in temperature.

Figure 46 schematically depicts an alternative measurement system. As shown in Figure 46, in an embodiment the measurement system 70 comprises three two-dimensional sensors 73. The stage 202 may comprise an edge grating 87. The edge grating 87 may have a pattern that is axial and/or circumferential relative to an axis of rotation of the movable member 20 relative to the support member 30. For example, the edge grating 87 may have a pattern that is both axial and circumferential relative to the Y axis. As shown in Figure 46, the edge grating 87 may be provided such that it is visible at an outer edge of the stage 202. The two-dimensional sensors 73 may be located so as to measure the curved side of the movable member 20. The two-dimensional sensors 73 may be configured to determine the position of the movable member 20 in six degrees of freedom.

In an embodiment the edge grating 87 is reflective. The edge grating 87 is visible to the two-dimensional sensors 73 located around the stage 202. In an embodiment the two-dimensional sensors 73 are configured to monitor the position of the stage 202 substantially continuously.

In an embodiment the edge grating 87 is etched onto the side of the stage 202. Alternatively, the edge grating 87 may be etched onto a strip that is subsequently assembled onto the stage 202. The strip may be formed of a substantially non-deformable material i.e. a material with a particularly low coefficient of thermal expansion.

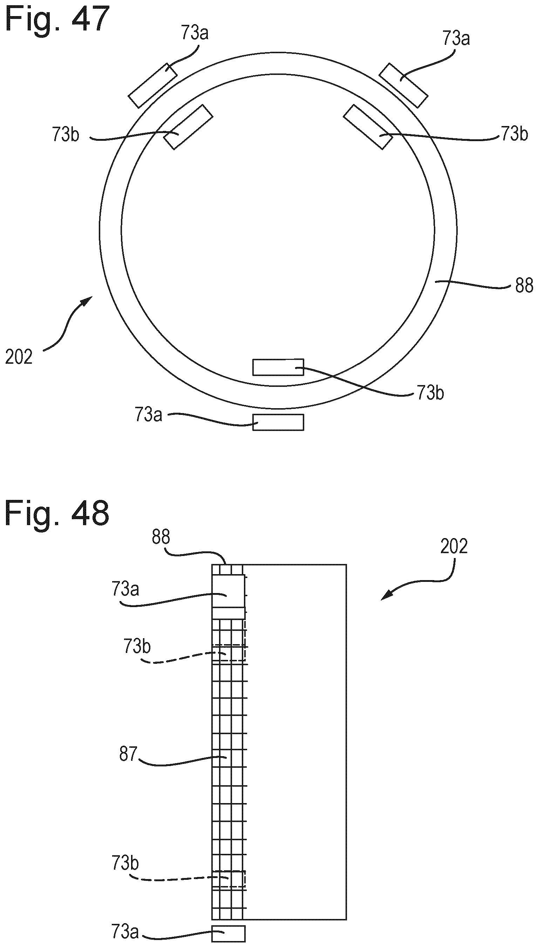

Figure 47 schematically depicts an alternative measurement system 70 for the stage 202. Figure 47 is a face view of the measurement system 70. Figure 48 schematically depicts a side view of the same measurement system 70.

In an embodiment the edge grating 87 is semi-transparent. This allows illumination to come from one side and the signal to be measured from both the inside and outside of the edge grating 87. This may help to increase the positioning accuracy.

As shown in Figure 47, in an embodiment the stage 202 comprises a rim 88. The rim 88 may extend circumferentially around the movable member 20. The rim 88 may comprise the edge grating 87. In an embodiment the rim 88 is at least partially transparent. This allows the edge grating 87, as part of the rim 88, to be measured from both sides of the edge grating 87.

As shown in Figure 47, in an embodiment first two-dimensional sensors 73a may be located radially outward of the rim 88. Second two-dimensional sensors 73b may be located radially inwardly of the rim 88.

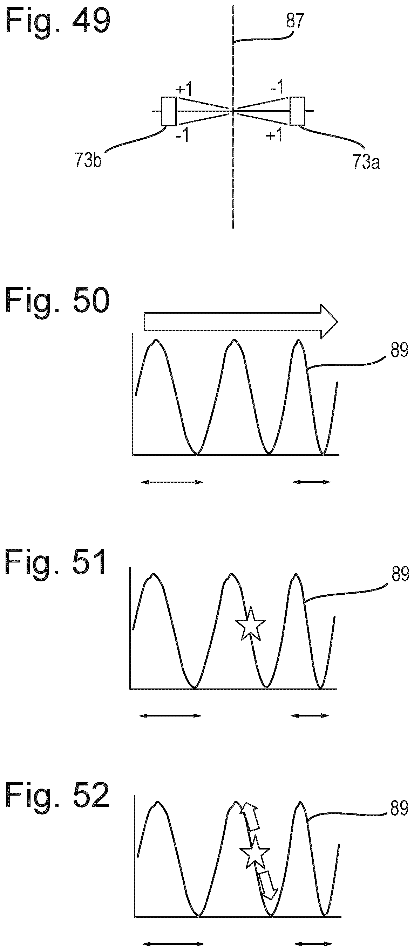

Figure 49 is a diagram showing the measurement of the edge grating 87 from both sides of the edge grating 87 by a first two-dimensional sensor 73a and a second two-dimensional sensor 73b. By measuring from both sides, the positioning accuracy may be increased. In particular, tilt-defocus sensitivity errors for each pair of two-dimensional sensors 73a, 73b may be cancelled out. By measuring on both sides, positioning error of the edge grating 87 has opposite effects on the signal by the different two-dimensional sensors 73a, 73b. In an embodiment the measurement error can be substantially corrected when the two two-dimensional sensors 73a, 73b have substantially the same sensitivity errors. In an embodiment, pairs of two-dimensional sensors 73 can be matched to each other to have the most similar sensitivity errors, such that the sensitivity errors can be maximally cancelled out during use.

In an embodiment the gratings mentioned above may have substantially consistent period. In an alternative embodiment, a varying pitch (i.e. varying period) may be provided to enable coarse positioning in a calibration measurement, and fine positioning in a continuous measurement.

For example, in an embodiment the pitch may alternate between a maximum pitch and a minimum pitch. The maximum pitch may be, for example, 1µm. The minimum pitch may be, for example, 0.5 µm. Alternative numbers of different pitches and their repeat frequency can be used. Alternative values for the maximum pitch and minimum pitch may be used. For example, the minimum pitch may be less than 0.5 µm. The minimum pitch may be as small as can be achieved during manufacture.

The pattern of the varying pitch may be repeated around the circumferential direction. For example, the maximum pitch may be provided at four locations. The coarse positioning can determine the drum within a 90° angle. It is not essential for the varying pitch to be repeated four times. Any number of repeats can be used. When a large number of repeats is used, then the angle within which the angle is required to be known by the coarse positioning is reduced. For example, when there are eight repeats, then the coarse positioning may determine the angle within a 45° angle. It is not essential for there to be any repeat at all.

Figure 50, Figure 51 and Figure 52 schematically show different steps of a measurement sequence. As shown in Figure 50, in an embodiment a grating with a varying pitch 89 may be scanned. The scan is shown by the large arrow at the top of Figure 50. As can be seen, the pitch is greater towards the left-hand side of Figure 50. The pitch is smaller towards the right-hand side of Figure 50. The varying pitches indicated by the double-ended arrows of different sizes at the bottom of Figure 50.

As shown in Figure 51, in an embodiment the position (of the movable member 20) may be determined following the scan. The position is indicated by the star shown in Figure 51.

As shown in Figure 52, continuous measurement may subsequently be performed to keep track of the position. The continuous measurement and tracking is indicated by the arrows extending away from the star in Figure 52.

Further embodiments of the invention are disclosed in the list of numbered clauses below:
1. A stage for die placement comprising:
   a support member;
   a movable member that is movable relative to the support member, wherein the movable member is configured to hold at least one die; and
   an actuator configured, on actuation, to move the movable member relative to the support member in six degrees of freedom.
2. The stage of clause 1, wherein the actuator is a Lorentz force actuator comprising:
   a magnet track comprised in one of the support member and the movable member, the magnet track comprising magnetic field generating elements for providing a magnetic field within a channel defined by the magnet track; and
   a plurality of coils comprised in the other of the movable member and the support member, the coils arranged at least partly within the channel such that relative movement between the coils and the magnet track causes relative movement between the support member and the movable member.
3. The stage of clause 2, wherein the magnet track is arranged such that the channel forms a closed loop.
4. The stage of clause 3, wherein the magnet track is arranged such that the channel is substantially annular.
5. The stage of any of clauses 2-4, wherein the plurality of coils comprises at least three groups of coils, each group comprising at least three coils arranged such that Lorentz forces are applicable between the coils and the magnet track in two degrees of freedom.
6. The stage of clause 5, comprising:
   a commutator configured to apply commutations to the coils such that the Lorentz forces in the different degrees of freedom are substantially independently controllable.
7. The stage of clause 5 or 6, wherein the groups have substantially fixed positions relative to each other.
8. The stage of any of clauses 2-7, wherein the magnet track is comprised in the movable member and the coils are comprised in the support member.
9. The stage of any of clauses 2-8, wherein the magnet track comprises two series of magnetic field generating elements on opposing sides of the channel, each series comprising magnetic field generating elements of alternating polarity distanced from each other.
10. The stage of clause 9, wherein at least one of the series of magnetic field generating elements comprises at least one Halbach magnet connecting adjacent magnetic field generating elements.
11. The stage of clause 9 or 10, comprising magnet supports configured to mechanically support respective series of magnetic field generating elements.
12. The stage of clause 11, wherein the magnet supports comprise a magnetic material.
13. The stage of any of clauses 2-12, comprising:
   a thermal conditioner configured to thermally condition the coils.
14. The stage of any of clauses 2-13, comprising:
   a stroke limiter configured to prevent the coils from moving out of the channel.
15. The stage of any preceding clause, configured such that the movable member is rotatable relative to the support member with an infinite stroke.
16. The stage of any preceding clause, comprising:
   a long stroke actuator configured, on actuation, to move the support member and the movable member in a long stroke direction, wherein the stroke of the support member and the movable member in the long stroke direction actuated by the long stroke actuator is longer than the stroke of the movable member relative to the support member in the long stroke direction actuated by the actuator.
17. The stage of any preceding clause, comprising:
   a gravity compensator fixed relative to the support member and configured to compensate for gravity on the moveable member.
18. The stage of any preceding clause, comprising:
   a secondary member that is movable relative to the support member and the movable member; and
   a secondary actuator configured, on actuation, to move the secondary member relative to the support member and/or the movable member;
   wherein the secondary member is configured to controllably contact the movable member so as to apply a force to the movable member during acceleration of the movable member relative to the support member.
19. The stage of clause 18, wherein the secondary member is configured to be distanced from the movable member during substantially constant motion of the movable member relative to the support member.
20. The stage of clause 18 or 19, wherein the secondary member is configured to apply the force in the direction of the acceleration.
21. The stage of any of clauses 18-20, wherein the secondary member comprises a flexible member configured to flex when the secondary member contacts the movable member.
22. The stage of clause 21, wherein the secondary member is configured such that the flexible member has a stiffness dependent on a position of the secondary member relative to the movable member.
23. The stage of any of clauses 18-22, wherein the secondary member is configured to controllably contact the movable member so as to apply a force to the movable member during acceleration of the movable member relative to the support member in at least two degrees of freedom.
24. The stage of any preceding clause, comprising:
   an angle measurement surface tilted relative to a plane perpendicular to an axis of rotation of the movable member relative to the support member, such that an angle of rotation of the movable member can be determined by measuring the angle measurement surface.
25. The stage of any preceding clause, comprising:
   an angle measurement grating with a pattern that is radial relative to an axis of rotation of the movable member relative to the support member, such that an angle of rotation of the movable member can be determined by measuring the angle measurement grating.
26. The stage of clause 25, comprising:
   a plurality of the angle measurement grating located at different radial positions.
27. The stage of any preceding clause, comprising:
   a translation measurement grating with a pattern that is circumferential relative to an axis of rotation of the movable member relative to the support member, such that translational movement of the movable member can be determined by measuring the translation measurement grating.
28. The stage of clause 27, wherein the translation measurement grating comprises circles of different radii at the same axial position along the axis of rotation.
29. The stage of any preceding clause, comprising:
   a plurality of rectangular gratings adjacent respective locations of the stage where a die can be held.
30. The stage of any preceding clause, comprising:
   an edge grating with a pattern that is axial and/or circumferential relative to an axis of rotation of the movable member relative to the support member.
31. The stage of clause 30, wherein the edge grating is arranged such that it can be measured from both sides of the surface on which the edge grating is provided.
32. The stage of clause 30 or 31, wherein a period of the edge grating varies.
33. A bonding tool for bonding a die to an acceptor substrate, the bonding tool comprising the stage of any preceding clause.
34. The bonding tool of clause 33, comprising:
   a base frame;
   a metrology frame; and
   an isolator configured to substantially isolate the metrology frame from the base frame;
   wherein the support member is secured to the base frame.
35. The bonding tool of clause 34, comprising:
   a measurement sensor configured to measure a position of the at least one die relative to the metrology frame.
36. The bonding tool of clause 35, comprising:
   a controller configured to control relative movement between the support member and the movable member based on data from the measurement sensor.
37. The bonding tool of clause 33 or 34, comprising:
   a measurement system configured to measure a position of the movable member in at least three degrees of freedom.
38. The bonding tool of clause 37, wherein the stage comprises a plurality of die acceptors configured to hold respective dies, wherein the measurement system is configured to measure a position of at least one of the die acceptors.
39. The bonding tool of clause 38, wherein the measurement system is configured to measure the position of the at least one of the die acceptors (a) during rotation of the movable member relative to the support member to a first level of accuracy and (b) during placement of a die onto the acceptor substrate to a second level of accuracy, wherein the second level of accuracy is greater than the first level of accuracy.
40. The bonding tool of any of clauses 37-39, comprising:
   a controller configured to control relative movement between the support member and the movable member based on data from the measurement system.
41. A method of placing a die, the method comprising:
   actuating an actuator to move a movable member relative to a support member in six degrees of freedom, wherein the movable member holds at least one die.
42. An actuator configured to drive a rotating movement comprising:
   a first member comprising a circularly arranged plurality of coils; and
   a second member that is rotatable relative to the first member and comprising a plurality of magnetic field generating elements arranged substantially concentric with the plurality of coils, characterized in that at least one magnetic field generating element and coil are relatively positioned such to enable force generation in a direction perpendicular to the rotating movement.
43. The actuator of clause 42, wherein the magnetic field generating elements are permanent magnets.
44. The actuator of any of clauses 42-43, wherein the plurality of coils comprises at least three groups of coils, each group comprising at least three coils arranged such that Lorentz forces are applicable between the coils and the plurality of magnetic field generating elements in at least two degrees of freedom.
45. The actuator of clause 44, comprising:
   a commutator configured to apply commutations to the coils such that the Lorentz forces in the at least two degrees of freedom are substantially independently controllable.
46. The actuator of any of clauses 44-45, wherein the groups have substantially fixed positions relative to each other.
47. The actuator of any of clauses 42-46, wherein the magnetic field generating elements are part of a magnet track that is comprised in the movable member and the coils are comprised in the support member.
48. The actuator of clause 47, wherein the magnet track comprises two series of magnetic field generating elements s on opposing sides of the channel, each series comprising magnetic field generating elements of alternating polarity distanced from each other.
49. The actuator of any of clauses 42-48, wherein at least one of the plurality of magnetic field generating elements comprises at least one Halbach magnet connecting adjacent magnetic field generating elements.
50. The actuator of any of clauses 42-49, comprising magnet supports configured to mechanically support respective magnetic field generative elements.
51. The actuator of clause 50, wherein the magnet supports comprise a magnetic material.
52. The actuator of any of clauses 42-51, comprising a thermal conditioner configured to thermally condition the coils.
53. The actuator of any of clauses 42-52, comprising a stroke limiter configured to prevent the coils from moving.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A stage for die placement comprising:
a support member;
a movable member that is movable relative to the support member, wherein the movable member is configured to hold at least one die; and
an actuator configured, on actuation, to move the movable member relative to the support member in six degrees of freedom.

2. The stage of claim 1, wherein the actuator is a Lorentz force actuator.

3. The stage of claim 2, wherein the Lorentz force actuator comprises:
a magnet track comprised in one of the support member and the movable member, the magnet track comprising magnetic field generating elements configured to provide a magnetic field within a channel defined by the magnet track; and
a plurality of coils comprised in the other of the movable member and the support member, the coils arranged at least partly within the channel such that relative movement between the coils and the magnet track causes relative movement between the support member and the movable member.

4. The stage of claim 3, wherein the magnet track is arranged such that the channel forms a closed loop.

5. The stage of claim 4, wherein the magnet track is arranged such that the channel is substantially annular and the Lorentz force actuator is configured to rotate the movable member relative to the support member .

6. The stage of claim 5, wherein the plurality of coils comprises at least three groups of coils, each group comprising at least three coils arranged such that Lorentz forces are applicable between the coils and the magnet track in two degrees of freedom.

7. The stage of claim 6, comprising:
a commutator configured to apply commutations to the coils such that the Lorentz forces in the different degrees of freedom are substantially independently controllable.

8. The stage of claim 6, wherein the groups have substantially fixed positions relative to each other.

9. The stage of claim 5, wherein the magnet track is comprised in the movable member and the coils are comprised in the support member.

10. The stage of claim 5, wherein the magnet track comprises two series of magnetic field generating elements on opposing sides of the channel, each series comprising magnetic field generating elements of alternating polarity distanced from each other.

11. The stage of claim 5, comprising:
a long stroke actuator configured, on actuation, to move the support member and the movable member in a long stroke direction, wherein the stroke of the support member and the movable member in the long stroke direction actuated by the long stroke actuator is longer than the stroke of the movable member relative to the support member in the long stroke direction actuated by the actuator.

12. The stage of claim 5, comprising:
an angle measurement surface tilted relative to a plane perpendicular to an axis of rotation of the movable member relative to the support member, such that an angle of rotation of the movable member can be determined by measuring the angle measurement surface.

13. A bonding tool for bonding a die to an acceptor substrate, the bonding tool comprising the stage of claim 1.

14. An actuator configured to drive a rotating movement comprising:
a first member comprising a circularly arranged plurality of coils; and
a second member that is rotatable relative to the first member and comprising a plurality of magnetic field generating elements arranged substantially concentric with the plurality of coils, **characterized in that** at least one magnetic field generating element and coil are relatively positioned such to enable force generation in a direction perpendicular to the rotating movement.

15. A method of placing a die, the method comprising:
actuating a Lorentz force actuator to move a movable member relative to a support member in six degrees of freedom, wherein the movable member holds at least one die.
